# EUROPEAN PATENT SPECIFICATION

(11) **EP 4 216 282 B1**
(45) Date of publication and mention of the grant of the patent: **11.11.2026**
(21) Application number: 22199501.2
(22) Date of filing: 04.10.2022
(51) Int. Cl.: H10D 30/01, H10D 30/43, H10D 30/67, H10D 62/10, H10D 62/13, H10D 62/40, H10D 64/01, H10D 64/23, H10D 84/01, H10D 84/03, H10D 84/83, B82Y 10/00, H10D 30/69, H10D 62/822

(54) **SEMICONDUCTOR DEVICE AND METHOD OF FABRICATING THE SAME**
HALBLEITERVORRICHTUNG UND VERFAHREN ZU DEREN HERSTELLUNG
DISPOSITIF SEMI-CONDUCTEUR ET SON PROCÉDÉ DE FABRICATION

(30) Priority: 19.01.2022 KR 20220007849
(43) Date of publication of application: 26.07.2023
(73) Proprietor: Samsung Electronics Co., Ltd., Gyeonggi-do 16677 (KR)
(72) Inventor: KIM, Seungku, 16677 Suwon-si (KR); PARK, Yonghee, 16677 Suwon-si (KR); SHIN, Dong-Gwan, 16677 Suwon-si (KR); KIM, Dae Sin, 16677 Suwon-si (KR); KIM, Sangyong, 16677 Suwon-si (KR); YOU, Joohyung, 16677 Suwon-si (KR)
(74) Representative: Marks & Clerk LLP

(56) References cited:
- US-A1- 2020 105 759
- US-A1- 2021 134 785
- US-A1- 2021 343 841
- US-B1- 11 018 222
- US-B2- 10 916 655

## Description

### BACKGROUND

The present inventive concepts relate to semiconductor devices and methods of fabricating the same, and in particular, to semiconductor devices including a field effect transistor and methods of fabricating the same.

A semiconductor device can include an integrated circuit comprising metal-oxide-semiconductor field-effect transistors (MOS-FETs). To meet an increasing demand for semiconductor devices with a small pattern size and a reduced design rule, MOS-FETs are being aggressively scaled down. The scale-down of the MOS-FETs may lead to deterioration in operational properties of the semiconductor device. A variety of studies are being conducted to overcome technical limitations associated with the scale-down of semiconductor devices and to realize semiconductor devices with high performance.

US 2021/134785 A1 discloses a semiconductor device and a method of fabricating the same. The semiconductor device includes a first channel pattern CH 1 and a second channel pattern CH 2. A gate dielectric pattern GI may cover the first top surface TS 1 and the first side surface SW 1 of the first channel pattern CH 1. The gate dielectric pattern GI may cover the second top surface TS 2 and opposite second side surfaces SW 2 of the second channel pattern CH2.

US 2021/343841 A1 discloses a semiconductor device including a substrate including a first region and a second region, a first active pattern extending upward from the first region, a first superlattice pattern on the first active pattern, a first active fin centrally disposed on the first active pattern, a first gate electrode disposed on the first active fin, and first source/drain patterns disposed on opposing sides of the first active fin and on the first active pattern.

US 10916655 B2 discloses a ferroelectric semiconductor device including an active region extending in one direction, a gate insulating layer crossing the active region, a ferroelectric layer disposed on the gate insulating layer and including a hafnium oxide, a gate electrode layer disposed on the ferroelectric layer, and source/drain regions disposed on the active region to be adjacent to both sides of the gate insulating layer.

US 2020/105759 A1 discloses an Integrated circuit structure including a fin, and a gate stack over the fin. The gate stack includes a high-k gate dielectric layer and a metal gate electrode.

US 11,018,222 B1 discloses structures, methods, and assemblies related to metallization in integrated circuit (IC) structures. An IC structure may include a first nanowire in a metal region and a second nanowire in the metal region. A gate electric may be disposed on and all around each of the nanowires.

### SUMMARY

Some example embodiments of the inventive concepts provide a semiconductor device with improved electrical characteristics.

Some example embodiments of the inventive concepts provide a method of fabricating a semiconductor device with improved electrical characteristics.

According to some example embodiments of the inventive concepts, there is provided a semiconductor device according to claim 1.

According to some example embodiments of the inventive concepts, there is provided a method according to claim 11.

At least some of the above and other features of the invention are set out in the claims.

### BRIEF DESCRIPTION OF THE DRAWINGS

FIGS. 1, 2, and 3 are conceptual diagrams illustrating logic cells of a semiconductor device according to some example embodiments of the inventive concepts.
FIG. 4 is a plan view illustrating a semiconductor device according to some example embodiments of the inventive concepts.
FIGS. 5A, 5B, 5C, and 5D are sectional views taken along lines A-A', B-B', C-C', and D-D', respectively, of FIG. 4.
FIG. 6A is an enlarged sectional view illustrating a portion 'M' of FIG. 5A.
FIG. 6B is an enlarged sectional view illustrating a portion 'N' of FIG. 5D.
FIGS. 7A, 7B, 8A, 8B, 9A, 9B, 9C, 10A, 10B, 10C, 11A, 11B, 11C, 12A, 12B, and 12C are sectional views illustrating a method of fabricating a semiconductor device, according to some example embodiments of the inventive concepts.
FIGS. 13A, 14A, and 15A are enlarged sectional views illustrating a method of forming a portion 'M' of FIG. 11A.
FIGS. 13B, 14B, and 15B are enlarged sectional views illustrating a method of forming a portion 'N' of FIG. 11C.
FIGS. 16A, 17A, and 18 are enlarged sectional views, each of which illustrates the portion 'M' of FIG. 5A according to some example embodiments of the inventive concepts.
FIGS. 16B and 17B are enlarged sectional views, each of which illustrates the portion 'N' of FIG. 5D according to some example embodiments of the inventive concepts.

### DETAILED DESCRIPTION

Example embodiments of the inventive concepts will now be described more fully with reference to the accompanying drawings, in which some example embodiments are shown.

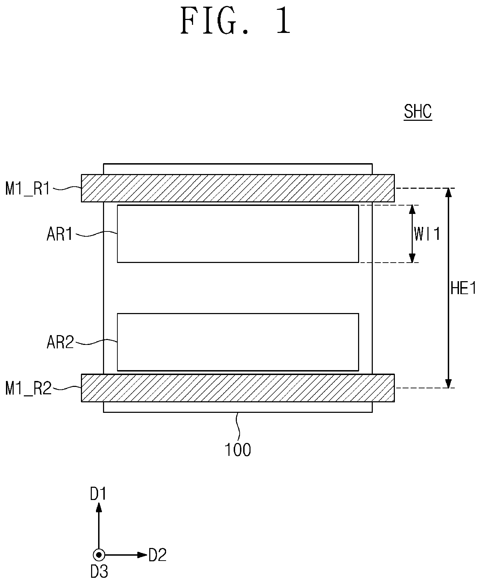

FIGS. 1, 2, and 3 are conceptual diagrams illustrating logic cells of a semiconductor device according to some example embodiments of the inventive concepts.

Referring to FIG. 1, a single height cell SHC may be provided. In detail, a first power line M1_R1 and a second power line M1_R2 may be provided on a substrate 100. The first power line M1_R1 may be a conduction path, to which a source voltage VSS (e.g., a ground voltage) is provided. The second power line M1_R2 may be a conduction path, to which a drain voltage (VDD) (e.g., a power voltage) is provided.

The single height cell SHC may be defined between the first power line M1_R1 and the second power line M1_R2. The single height cell SHC may include one first active region AR1 and one second active region AR2. One of the first and second active regions AR1 and AR2 may be a p-channel MOSFET (PMOSFET) region, and the other may be an n-channel MOSFET (NMOSFET) region. In other words, the single height cell SHC may have a complementary metal-oxide-semiconductor (CMOS) structure provided between the first and second power lines M1_R1 and M1_R2.

Each of the first and second active regions AR1 and AR2 may have a first width WI1 in a first direction D1. A length of the single height cell SHC in the first direction D1 may be defined as a first height HE1. The first height HE1 may be substantially equal to a distance (e.g., a pitch) between the first and second power lines M1_R1 and M1_R2 (e.g. in the first direction D1). The first direction D1 may be parallel to a top surface of the substrate 100.

The single height cell SHC may constitute a single logic cell. In the present specification, the logic cell may mean a logic device (e.g., AND, OR, XOR, XNOR, inverter, and so forth), which is configured to execute a specific function. In other words, the logic cell may include transistors constituting the logic device and interconnection lines connecting transistors to each other.

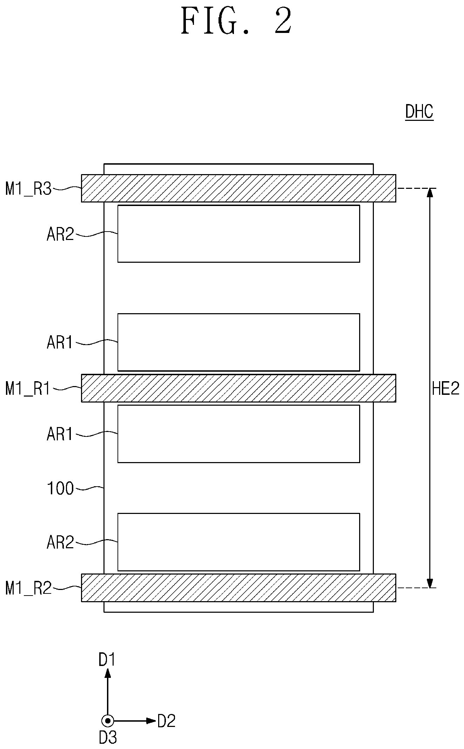

Referring to FIG. 2, a double height cell DHC may be provided. In detail, a first power line M1_R1, a second power line M1_R2, and a third power line M1_R3 may be provided on the substrate 100. The first power line M1_R1 may be disposed between the second power line M1_R2 and the third power line M1_R3. The third power line M1_R3 may be a conduction path, to which the source voltage (VSS) is provided.

The double height cell DHC may be defined between the second power line M1_R2 and the third power line M1_R3. The double height cell DHC may include a pair of first active regions AR1 and a pair of second active regions AR2.

One of the second active regions AR2 may be adjacent to the second power line M1_R2. The other of the second active regions AR2 may be adjacent to the third power line M1_R3. The pair of the first active regions AR1 may be adjacent to the first power line M1_R1. When viewed in a plan view, the first power line M1_R1 may be disposed between the pair of the first active regions AR1.

A length of the double height cell DHC in the first direction D1 may be defined as a second height HE2. The second height HE2 may be about two times the first height HE1 of FIG. 1. The pair of the first active regions AR1 of the double height cell DHC may be combined to serve as a single active region.

In some example embodiments, the double height cell DHC shown in FIG. 2 may be defined as a multi-height cell. Although not shown, the multi-height cell may include a triple height cell whose cell height is about three times that of the single height cell SHC.

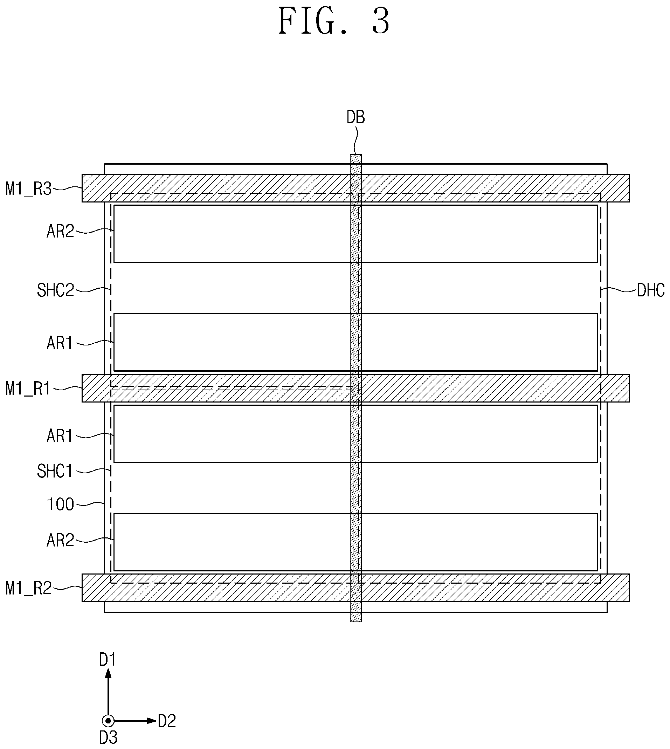

Referring to FIG. 3, a first single height cell SHC1, a second single height cell SHC2, and a double height cell DHC may be two-dimensionally arranged on the substrate 100. The first single height cell SHC1 may be disposed between the first and second power lines M1_R1 and M1_R2. The second single height cell SHC2 may be disposed between the first and third power lines M1_R1 and M1_R3. The second single height cell SHC2 may be adjacent to the first single height cell SHC1 in the first direction D1.

The double height cell DHC may be disposed between the second and third power lines M1_R2 and M1_R3. The double height cell DHC may be adjacent to the first and second single height cells SHC1 and SHC2 in a second direction D2. The second direction D2 may be perpendicular to the first direction D1. The second direction D2 may be parallel to a top surface of the substrate 100.

A division structure DB may be provided between the first single height cell SHC1 and the double height cell DHC and between the second single height cell SHC2 and the double height cell DHC. The active regions of the double height cell DHC may be electrically separated from the active regions of each of the first and second single height cells SHC1 and SHC2 by the division structure DB.

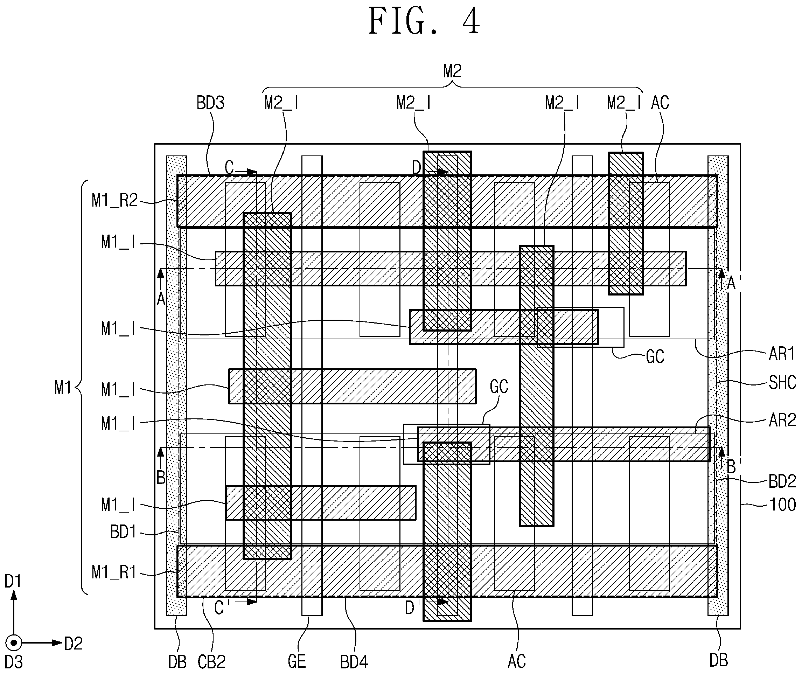

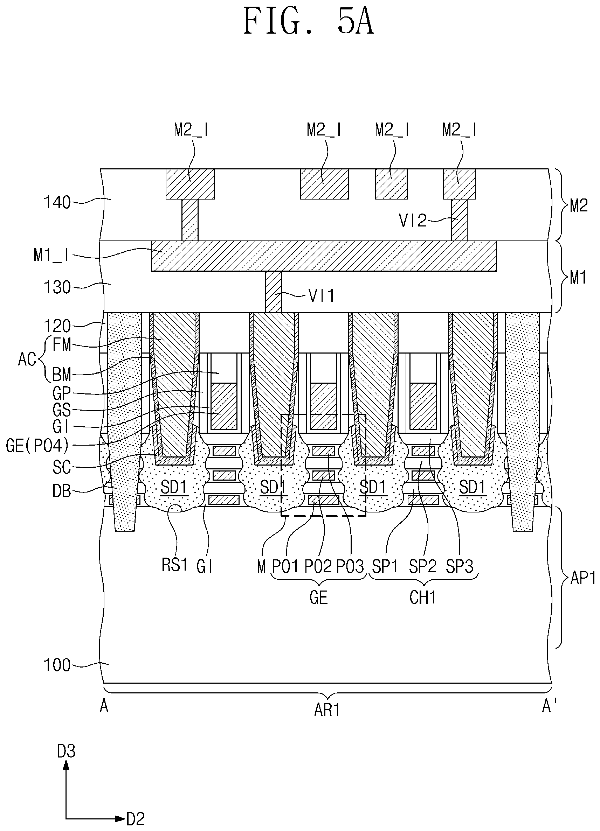

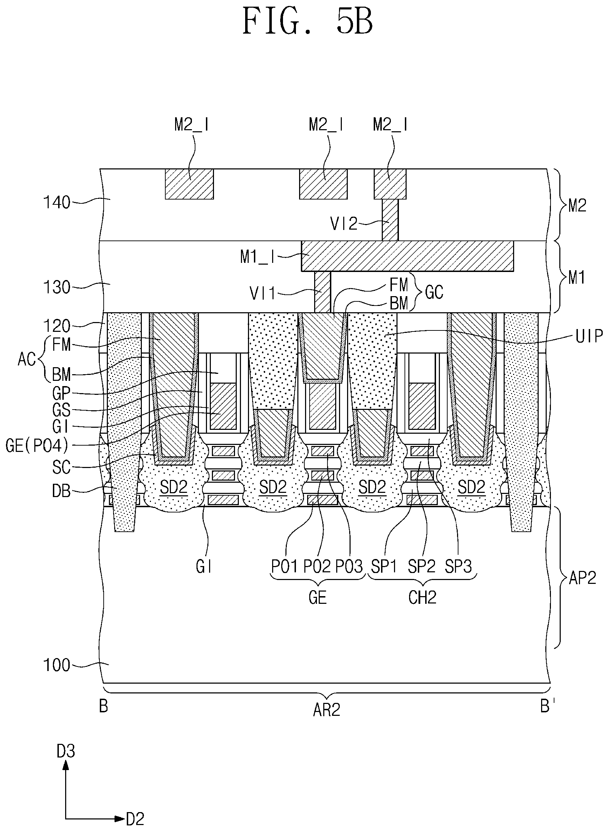

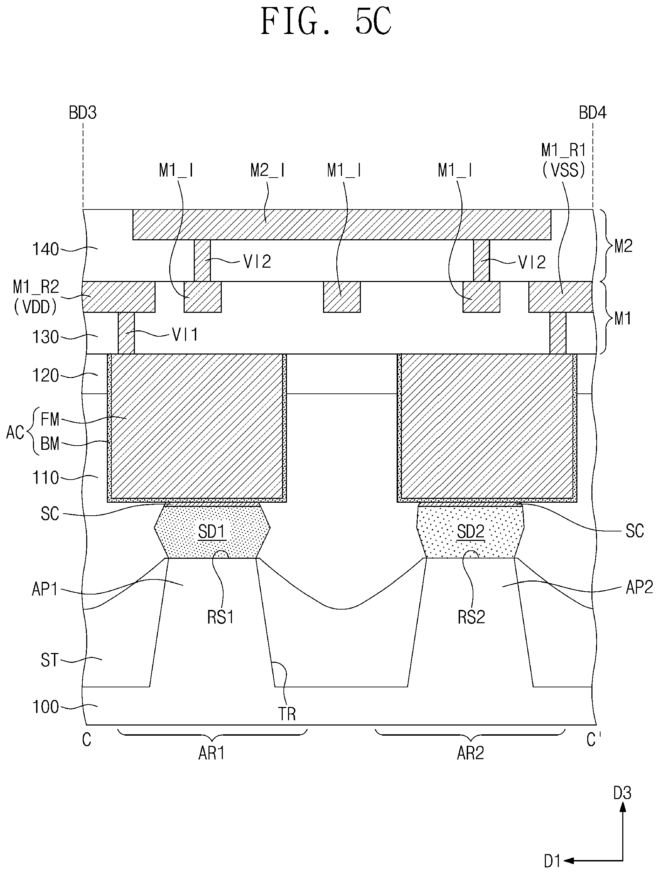

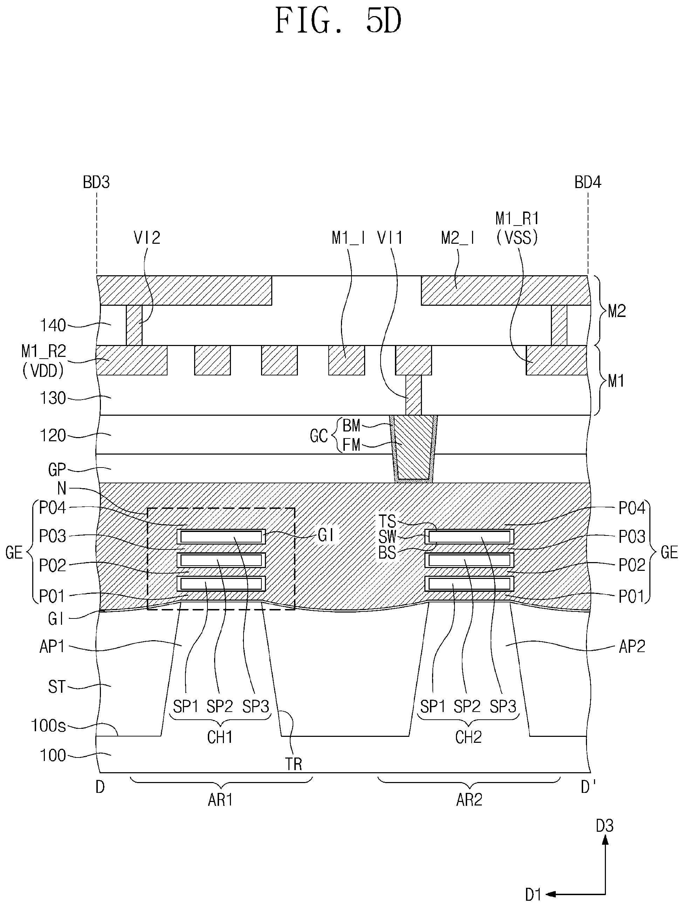

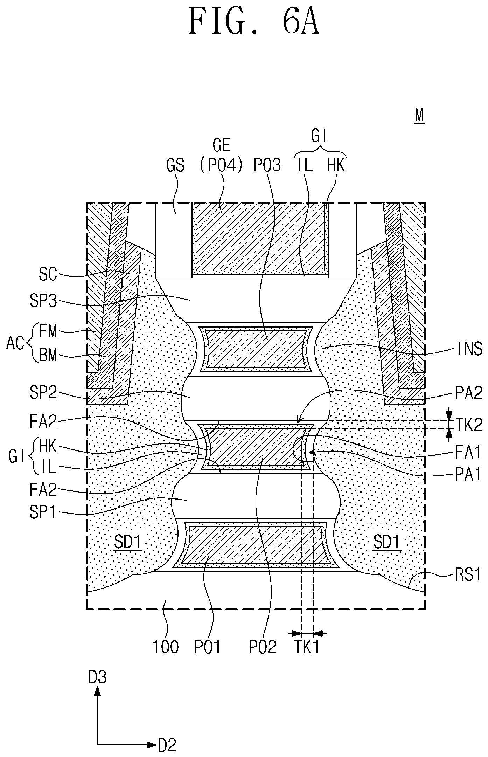

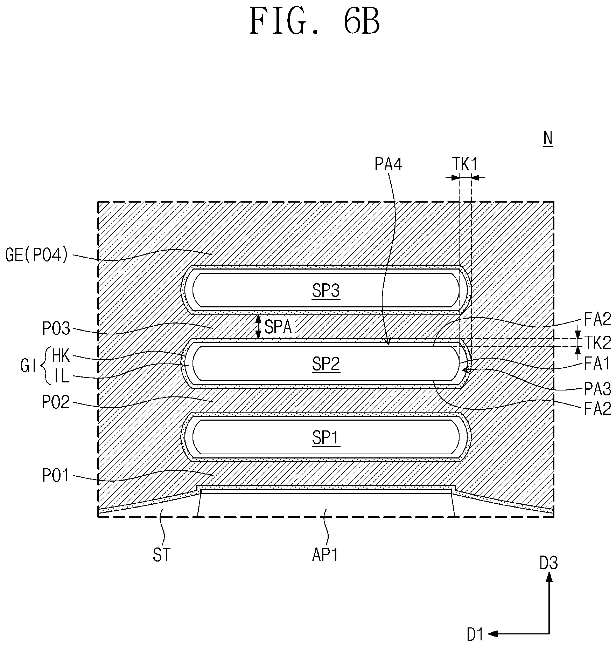

FIG. 4 is a plan view illustrating a semiconductor device according to some example embodiments of the inventive concepts. FIGS. 5A, 5B, 5C, and 5D are sectional views taken along lines A-A', B-B', C-C', and D-D', respectively, of FIG. 4. FIG. 6A is an enlarged sectional view illustrating a portion 'M' of FIG. 5A. FIG. 6B is an enlarged sectional view illustrating a portion 'N' of FIG. 5D. The semiconductor device of FIGS. 4 and 5A to 5D may be a concrete example of the single height cell SHC of FIG. 1.

Referring to FIGS. 4, 5A, 5B, 5C, and 5D, the single height cell SHC may be provided on the substrate 100. Logic transistors constituting a logic circuit may be disposed on the single height cell SHC. The substrate 100 may be a semiconductor substrate that is formed of or includes silicon, germanium, silicon germanium, a compound semiconductor material, or the like. In some example embodiments, the substrate 100 may be a silicon wafer.

The substrate 100 may include the first active region AR1 and the second active region AR2. Each of the first and second active regions AR1 and AR2 may be extended in the second direction D2. In some example embodiments, the first active region AR1 may be an NMOSFET region, and the second active region AR2 may be a PMOSFET region.

A first active pattern AP1 and a second active pattern AP2 may be defined by a trench TR, which is formed in an upper portion of the substrate 100. The first active pattern AP1 may be provided on the first active region AR1, and the second active pattern AP2 may be provided on the second active region AR2. The first and second active patterns AP1 and AP2 may be extended in the second direction D2. Each of the first and second active patterns AP1 and AP2 may be a vertically-protruding portion of the substrate 100. The vertical protrusions may be along a third direction D3 that is perpendicular to the first direction D1 and second direction D2.

A device isolation layer ST may be provided on the substrate 100. The device isolation layer ST may be provided to fill the trench TR. The device isolation layer ST may include a silicon oxide layer. The device isolation layer ST may not cover first and second channel patterns CH1 and CH2 to be described below.

In some example embodiments, the first direction D1 may be understood to extend parallel to a top surface 100s of the substrate 100, the second direction D2 may be understood to extend parallel to the top surface 100s of the substrate 100 and perpendicular to the first direction D1, and the third direction D3 may be understood to extend perpendicular to the top surface 100s of the substrate 100 and extend perpendicular to both the first and second directions D1 and D2.

A first channel pattern CH1 may be provided on the first active pattern AP1. A second channel pattern CH2 may be provided on the second active pattern AP2. Each of the first and second channel patterns CH1 and CH2 may include a first semiconductor pattern SP1, a second semiconductor pattern SP2, and a third semiconductor pattern SP3, which are sequentially stacked. The first to third semiconductor patterns SP1, SP2, and SP3 may be spaced apart from each other in a vertical direction (i.e., a third direction D3).

Each of the first to third semiconductor patterns SP1, SP2, and SP3 may be formed of or include at least one of silicon (Si), germanium (Ge), or silicon germanium (SiGe). For example, each of the first to third semiconductor patterns SP1, SP2, and SP3 may be formed of or include crystalline silicon.

A plurality of first source/drain patterns SD1 may be provided on the first active pattern AP1. A plurality of first recesses RS1 may be formed in an upper portion of the first active pattern AP1. The first source/drain patterns SD1 may be provided in the first recesses RS1, respectively. The first source/drain patterns SD1 may be impurity regions of a first conductivity type (e.g., n-type). The first channel pattern CH1 may be interposed between each pair of the first source/drain patterns SD1. In other words, each pair of the first source/drain patterns SD1 may be connected to each other by the stacked first to third semiconductor patterns SP1, SP2, and SP3.

A plurality of second source/drain patterns SD2 may be provided on the second active pattern AP2. A plurality of second recesses RS2 may be formed in an upper portion of the second active pattern AP2. The second source/drain patterns SD2 may be provided in the second recesses RS2, respectively. The second source/drain patterns SD2 may be impurity regions of a second conductivity type (e.g., p-type). The second channel pattern CH2 may be interposed between each pair of the second source/drain patterns SD2. In other words, each pair of the second source/drain patterns SD2 may be connected to each other by the stacked first to third semiconductor patterns SP1, SP2, and SP3.

The first and second source/drain patterns SD1 and SD2 may be epitaxial patterns, which are formed by a selective epitaxial growth (SEG) process. In some example embodiments, each of the first and second source/drain patterns SD1 and SD2 may have a top surface that is higher than a top surface of the third semiconductor pattern SP3. In some example embodiments, a top surface of at least one of the first and second source/drain patterns SD1 and SD2 may be located at substantially the same level as the top surface of the third semiconductor pattern SP3.

In some example embodiments, the first source/drain patterns SD1 may be formed of or include the same semiconductor element (e.g., Si) as the substrate 100. The second source/drain patterns SD2 may include a semiconductor material (e.g., SiGe) whose lattice constant is greater than that of the substrate 100. In this case, the pair of the second source/drain patterns SD2 may exert a compressive stress on the second channel pattern CH2 therebetween.

A side surface of each of the first and second source/drain patterns SD1 and SD2 may have an uneven or embossing shape. In other words, the side surface of each of the first and second source/drain patterns SD1 and SD2 may have a wavy profile, which may be understood to be a continuous wave profile (e.g., a sinusoidal wave) wherein the side surface varies in a horizontal direction (e.g., the second direction D2 as shown in FIG. 6A) as the side surface extends in the vertical direction (e.g., the third direction D3), for example varies according to a waveform. For example, the side surface of each of the first and second source/drain patterns SD1 and SD2 may have a wavy profile such that a position of the side surface oscillates perpendicularly to the third direction D3 (e.g., oscillates in the second direction D2) as the side surface of the source/drain pattern extends in the third direction D3. The side surface of each of the first and second source/drain patterns SD1 and SD2 may protrude toward first to third portions PO1, PO2, and PO3 of a gate electrode GE, which will be described below.

Gate electrodes GE may be provided to cross the first and second channel patterns CH1 and CH2 and to extend in the first direction D1. The gate electrodes GE may be arranged at a first pitch in the second direction D2. Each of the gate electrodes GE may be vertically overlapped with the first and second channel patterns CH1 and CH2.

The gate electrode GE may include a first portion PO1 interposed between the active pattern AP1 or AP2 and the first semiconductor pattern SP1, a second portion PO2 interposed between the first and second semiconductor patterns SP1 and SP2, a third portion PO3 interposed between the second and third semiconductor patterns SP2 and SP3, and a fourth portion PO4 on the third semiconductor pattern SP3.

Referring to FIG. 5D, the gate electrode GE may be provided on a top surface TS, a bottom surface BS, and opposite side surfaces SW of each of the first to third semiconductor patterns SP1, SP2, and SP3. That is, the transistor according to some example embodiments may be a three-dimensional field effect transistor (e.g., MBCFET or GAAFET) in which the gate electrode GE is provided to three-dimensionally surround the channel pattern.

Referring back to FIGS. 4 and 5A to 5D, a pair of gate spacers GS may be respectively disposed on opposite side surfaces of the fourth portion PO4 of the gate electrode GE. The gate spacers GS may be extended along the gate electrode GE and in the first direction D1. Top surfaces of the gate spacers GS may be higher than a top surface of the gate electrode GE. The top surfaces of the gate spacers GS may be coplanar with a top surface of a first interlayer insulating layer 110, which will be described below. In some example embodiments, the gate spacers GS may be formed of or include at least one of silicon carbon nitride (SiCN), silicon carbon oxynitride (SiCON), or silicon nitride (SiN). In some example embodiments, the gate spacers GS may be a multi-layered structure, which is formed of or includes at least two different materials selected from SiCN, SiCON, and SiN. For example, as illustrated in FIG. 6, the gate spacer GS may include a first spacer GS1 and a second spacer GS2.

A gate capping pattern GP may be provided on the gate electrode GE. The gate capping pattern GP may be extended along the gate electrode GE or in the first direction D1. The gate capping pattern GP may be formed of or include a material having an etch selectivity with respect to first and second interlayer insulating layers 110 and 120, which will be described below. In detail, the gate capping pattern GP may be formed of or include at least one of silicon oxynitride (SiON), SiCN, SiCON, or SiN.

A gate insulating layer GI may be interposed between the gate electrode GE and the first channel pattern CH1 and between the gate electrode GE and the second channel pattern CH2. The gate insulating layer GI may cover the top surface TS, the bottom surface BS, and the opposite side surfaces SW of each of the first to third semiconductor patterns SP1, SP2, and SP3. The gate insulating layer GI may cover a top surface of the device isolation layer ST below the gate electrode GE.

In some example embodiments, referring to FIGS. 6A and 6B, the gate insulating layer GI may include an interface layer IL and a high-k dielectric layer HK. The interface layer IL may include a silicon oxide layer or a silicon oxynitride layer. The high-k dielectric layer HK may be formed of or include a high-k dielectric material whose dielectric constant (k) is higher than silicon oxide. When comparing dielectric constants, the same test parameters may be utilized (e.g. the same temperature and frequency, e.g. as measured at room temperature (e.g. 293 K) for low (e.g. less than 1kHz) frequencies). As an example, the high-k dielectric layer HK may be formed of or include at least one of, for example, hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

In some example embodiments, the semiconductor device may include a negative capacitance (NC) field effect transistor (FET) using a negative capacitor. For example, the gate insulating layer GI may include a ferroelectric layer exhibiting a ferroelectric property and a paraelectric layer exhibiting a paraelectric property.

The ferroelectric layer may have a negative capacitance, and the paraelectric layer may have a positive capacitance. In the case where two or more capacitors are connected in series and each capacitor has a positive capacitance, a total capacitance may be reduced to a value that is less than a capacitance of each of the capacitors. By contrast, in the case where at least one of serially-connected capacitors has a negative capacitance, a total capacitance of the serially-connected capacitors may have a positive value and may be greater than an absolute value of each capacitance.

In the case where a ferroelectric layer having a negative capacitance and a paraelectric layer having a positive capacitance are connected in series, a total capacitance of the serially-connected ferroelectric and paraelectric layers may be increased. Due to such an increase of the total capacitance, a transistor including the ferroelectric layer may have a subthreshold swing (SS), which is less than 60 mV/decade, at the room temperature.

The ferroelectric layer may have the ferroelectric property. The ferroelectric layer may be formed of or include at least one of, for example, hafnium oxide, hafnium zirconium oxide, barium strontium titanium oxide, barium titanium oxide, and/or lead zirconium titanium oxide. Here, the hafnium zirconium oxide may be hafnium oxide that is doped with zirconium (Zr). Alternatively, the hafnium zirconium oxide may be a compound composed of hafnium (Hf), zirconium (Zr), and/or oxygen (O).

The ferroelectric layer may further include dopants. For example, the dopants may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and/or tin (Sn). The kind of the dopants in the ferroelectric layer may vary depending on a ferroelectric material included in the ferroelectric layer.

In the case where the ferroelectric layer includes hafnium oxide, the dopants in the ferroelectric layer may include at least one of, for example, gadolinium (Gd), silicon (Si), zirconium (Zr), aluminum (Al), and/or yttrium (Y).

In the case where the dopants are aluminum (Al), a content of aluminum in the ferroelectric layer may range from 3 to 8 at% (atomic percentage). Here, the content of the dopants (e.g., aluminum atoms) may be a ratio of the number of aluminum atoms to the number of hafnium and aluminum atoms.

In the case where the dopants are silicon (Si), a content of silicon in the ferroelectric layer may range from 2 at% to 10 at%. In the case where the dopants are yttrium (Y), a content of yttrium in the ferroelectric layer may range from 2 at% to 10 at%. In the case where the dopants are gadolinium (Gd), a content of gadolinium in the ferroelectric layer may range from 1 at% to 7 at%. In the case where the dopants are zirconium (Zr), a content of zirconium in the ferroelectric layer may range from 50 at% to 80 at%.

The paraelectric layer may have the paraelectric property. The paraelectric layer may be formed of or include at least one of, for example, silicon oxide and/or high-k metal oxides. The metal oxides, which can be used as the paraelectric layer, may include at least one of, for example, hafnium oxide, zirconium oxide, and/or aluminum oxide, but the inventive concepts is not limited to these examples.

The ferroelectric layer and the paraelectric layer may be formed of or include the same material. The ferroelectric layer may have the ferroelectric property, but the paraelectric layer may not have the ferroelectric property. For example, in the case where the ferroelectric and paraelectric layers contain hafnium oxide, a crystal structure of the hafnium oxide in the ferroelectric layer may be different from a crystal structure of the hafnium oxide in the paraelectric layer.

The ferroelectric layer may exhibit the ferroelectric property, only when its thickness is in a specific range. In some example embodiments, the ferroelectric layer may have a thickness ranging from 0.5 to 10 nm, but the inventive concepts is not limited to this example. Since a critical thickness associated with the occurrence of the ferroelectric property varies depending on the kind of the ferroelectric material, the thickness of the ferroelectric layer may be changed depending on the kind of the ferroelectric material.

As an example, the gate insulating layer GI may include a single ferroelectric layer. As another example, the gate insulating layer GI may include a plurality of ferroelectric layers spaced apart from each other. The gate insulating layer GI may have a multi-layered structure, in which a plurality of ferroelectric layers and a plurality of paraelectric layers are alternately stacked.

Referring back to FIGS. 4 and 5A to 5D, the gate electrode GE may include a first metal pattern and a second metal pattern on the first metal pattern. The first metal pattern may be provided on the gate insulating layer GI and may be adjacent to the first to third semiconductor patterns SP1, SP2, and SP3. The first metal pattern may include a work-function metal, which can be used to adjust a threshold voltage of the transistor. By adjusting a thickness and composition of the first metal pattern, it may be possible to realize a transistor having a desired threshold voltage. For example, the first to third portions PO1, PO2, and PO3 of the gate electrode GE may be composed of the first metal pattern or the work-function metal.

The first metal pattern may include a metal nitride layer. For example, the first metal pattern may include a layer that is composed of at least one metallic material, which is selected from the group consisting of titanium (Ti), tantalum (Ta), aluminum (Al), tungsten (W) and molybdenum (Mo), and nitrogen (N). In some example embodiments, the first metal pattern may further include carbon (C). The first metal pattern may include a plurality of work function metal layers which are stacked.

The second metal pattern may be formed of or include a metallic material whose resistance is lower than the first metal pattern. For example, the second metal pattern may be formed of or include at least one metallic material, which is selected from the group consisting of tungsten (W), aluminum (Al), titanium (Ti), and tantalum (Ta). The fourth portion PO4 of the gate electrode GE may include the first metal pattern and the second metal pattern on the first metal pattern.

A first interlayer insulating layer 110 may be provided on the substrate 100. The first interlayer insulating layer 110 may cover the gate spacers GS and the first and second source/drain patterns SD1 and SD2. The first interlayer insulating layer 110 may have a top surface that is substantially coplanar with the top surface of the gate capping pattern GP and the top surface of the gate spacer GS. A second interlayer insulating layer 120 may be formed on the first interlayer insulating layer 110 to cover the gate capping pattern GP. A third interlayer insulating layer 130 may be provided on the second interlayer insulating layer 120. A fourth interlayer insulating layer 140 may be provided on the third interlayer insulating layer 130. In some example embodiments, at least one of the first to fourth interlayer insulating layers 110 to 140 may include a silicon oxide layer.

The single height cell SHC may have a first border BD1 and a second border BD2, which are opposite to each other in the second direction D2. The first and second borders BD1 and BD2 may be extended in the first direction D1. The single height cell SHC may have a third border BD3 and a fourth border BD4, which are opposite to each other in the first direction D1. The third and fourth borders BD3 and BD4 may be extended in the second direction D2.

A pair of division structures DB, which are opposite to each other in the second direction D2, may be provided at both sides of the single height cell SHC. For example, the pair of the division structures DB may be respectively provided on the first and second borders BD1 and BD2 of the single height cell SHC. The division structure DB may be extended in the first direction D1 to be parallel to the gate electrodes GE. A pitch between the division structure DB and the gate electrode GE adjacent thereto may be equal to the first pitch.

The division structure DB may be provided to penetrate the first and second interlayer insulating layers 110 and 120 and may be extended into the first and second active patterns AP1 and AP2. The division structure DB may be provided to penetrate an upper portion of each of the first and second active patterns AP1 and AP2. The division structure DB may electrically separate an active region of each of the single height cell SHC from an active region of a neighboring cell.

Active contacts AC may be provided to penetrate the first and second interlayer insulating layers 110 and 120 and to be electrically connected to the first and second source/drain patterns SD1 and SD2, respectively. A pair of the active contacts AC may be respectively provided at both sides of the gate electrode GE. When viewed in a plan view, the active contact AC may be a bar-shaped pattern that is extended in the first direction D1.

The active contact AC may be a self-aligned contact. For example, the active contact AC may be formed by a self-alignment process using the gate capping pattern GP and the gate spacer GS. For example, the active contact AC may cover at least a portion of the side surface of the gate spacer GS. Although not shown, the active contact AC may cover a portion of the top surface of the gate capping pattern GP.

Metal-semiconductor compound layers SC (e.g., silicide layers) may be respectively interposed between the active contact AC and the first source/drain pattern SD1 and between the active contact AC and the second source/drain pattern SD2. The active contact AC may be electrically connected to the source/drain pattern SD1 or SD2 through the metal-semiconductor compound layer SC. For example, the metal-semiconductor compound layer SC may be formed of or include at least one of titanium silicide, tantalum silicide, tungsten silicide, nickel silicide, or cobalt silicide.

Gate contacts GC may be provided to penetrate the second interlayer insulating layer 120 and the gate capping pattern GP and to be electrically connected to the gate electrodes GE, respectively. When viewed in a plan view, the gate contacts GC may be disposed to be respectively overlapped with the first and second active regions AR1 and AR2. As an example, the gate contact GC may be provided on the second active pattern AP2 (e.g., see FIG. 5B).

In some example embodiments, referring to FIG. 5B, an upper portion of the active contact AC adjacent to the gate contact GC may be filled with an upper insulating pattern UIP. A bottom surface of the upper insulating pattern UIP may be lower than a bottom surface of the gate contact GC. In other words, a top surface of the active contact AC adjacent to the gate contact GC may be formed at a level, which is lower than the bottom surface of the gate contact GC, by the upper insulating pattern UIP. Accordingly, it may be possible to prevent the gate contact GC and the active contact AC, which are adjacent to each other, from being in contact with each other and thereby to prevent a short circuit issue from occurring therebetween.

Each of the active and gate contacts AC and GC may include a conductive pattern FM and a barrier pattern BM enclosing the conductive pattern FM. For example, the conductive pattern FM may be formed of or include at least one of metallic materials (e.g., aluminum, copper, tungsten, molybdenum, and cobalt). The barrier pattern BM may be provided to cover side and bottom surfaces of the conductive pattern FM. In some example embodiments, the barrier pattern BM may include a metal layer and a metal nitride layer. The metal layer may be formed of or include at least one of titanium, tantalum, tungsten, nickel, cobalt, or platinum. The metal nitride layer may be formed of or include at least one of titanium nitride (TiN), tantalum nitride (TaN), tungsten nitride (WN), nickel nitride (NiN), cobalt nitride (CoN), or platinum nitride (PtN).

A first metal layer M1 may be provided in the third interlayer insulating layer 130. For example, the first metal layer M1 may include the first power line M1_R1, the second power line M1_R2, and first interconnection lines M1_I. Each of the interconnection lines M1_R1, M1_R2, and M1_I of the first metal layer M1 may be extended in the second direction D2 and parallel to each other.

In detail, the first and second power lines M1_R1 and M1_R2 may be respectively provided on the third and fourth borders BD3 and BD4 of the single height cell SHC. The first power line M1_R1 may be extended along the third border BD3 and in the second direction D2. The second power line M1_R2 may be extended along the fourth border BD4 and in the second direction D2.

The first interconnection lines M1_I of the first metal layer M1 may be disposed between the first and second power lines M1_R1 and M1_R2. The first interconnection lines M1_I of the first metal layer M1 may be arranged at a second pitch in the first direction D1. The second pitch may be smaller than the first pitch. A linewidth of each of the first interconnection lines M1_I may be smaller than a linewidth of each of the first and second power lines M1_R1 and M1_R2.

The first metal layer M1 may further include first vias VI1. The first vias VI1 may be respectively disposed below the interconnection lines M1_R1, M1_R2, and M1_I of the first metal layer M1. The active contact AC and the interconnection line of the first metal layer M1 may be electrically connected to each other through the first via VI1. The gate contact GC and the interconnection line of the first metal layer M1 may be electrically connected to each other through the first via VI1.

The interconnection line of the first metal layer M1 and the first via VI1 thereunder may be formed by separate processes. For example, the interconnection line and the first via VI1 of the first metal layer M1 may be independently formed by respective single damascene processes. The semiconductor device according to some example embodiments may be fabricated using a sub-20 nm process.

A second metal layer M2 may be provided in the fourth interlayer insulating layer 140. The second metal layer M2 may include a plurality of second interconnection lines M2_I. Each of the second interconnection lines M2_I of the second metal layer M2 may be a line- or bar-shaped pattern that is extended in the first direction D1. In other words, the second interconnection lines M2_I may be extended in the first direction D1 and parallel to each other.

The second metal layer M2 may further include second vias VI2, which are respectively provided below the second interconnection lines M2_I. The interconnection lines of the first and second metal layers M1 and M2 may be electrically connected to each other through the second via VI2. The interconnection line of the second metal layer M2 and the second via VI2 thereunder may be formed together by a dual damascene process.

The interconnection lines of the first metal layer M1 may be formed of or include a conductive material that is the same as or different from those of the second metal layer M2. For example, the interconnection lines of the first and second metal layers M1 and M2 may be formed of or include at least one of metallic materials (e.g., aluminum, copper, tungsten, ruthenium, molybdenum, and cobalt). Although not shown, a plurality of metal layers (e.g., M3, M4, M5, and so forth) may be additionally stacked on the fourth interlayer insulating layer 140. Each of the stacked metal layers may include interconnection lines, which are used as routing paths between cells.

The gate insulating layer GI will be described in more detail with reference to FIGS. 6A and 6B. First, referring to FIG. 6A, each of the first to third portions PO1, PO2, and PO3 of the gate electrode GE may have a concave side surface. The concave side surfaces of the first to third portions PO1, PO2, and PO3 may correspond to protruding portions of the side surface of the first source/drain pattern SD1.

In some example embodiments, the first to third portions PO1, PO2, and PO3 may have different widths from each other. For example, the largest width of the third portion PO3 in the second direction D2 may be greater than the largest width of the second portion PO2 in the second direction D2. The largest width of the first portion PO1 in the second direction D2 may be greater than the largest width of the third portion PO3 in the second direction D2.

As an example, the second portion PO2 of the gate electrode GE and the gate insulating layer GI enclosing the second portion PO2 will be described below. The gate insulating layer GI may be interposed between the second portion PO2 and the first semiconductor pattern SP1, between the second portion PO2 and the second semiconductor pattern SP2, and between the second portion PO2 and the first source/drain pattern SD1.

The gate insulating layer GI may include the interface layer IL and the high-k dielectric layer HK. The interface layer IL may be provided to directly cover the first semiconductor pattern SP1, the second semiconductor pattern SP2, and the first source/drain pattern SD1. The high-k dielectric layer HK may be interposed between the interface layer IL and the second portion PO2. The high-k dielectric layer HK may be provided to directly cover a surface of the second portion PO2.

A thickness of the gate insulating layer GI may be a sum of a thickness of the interface layer IL and a thickness of the high-k dielectric layer HK. A thickness of the gate insulating layer GI in a horizontal direction (e.g., the second direction D2) may be a first thickness TK1. A thickness of the gate insulating layer GI in a vertical direction (e.g., the third direction D3) may be a second thickness TK2. The first thickness TK1 and the second thickness TK2 are different from each other. The first thickness TK1 is greater than the second thickness TK2. A ratio TK2/TK1 of the second thickness TK2 to the first thickness TK1 falls within a range from 0.3 to 0.8.

In some example embodiments, the high-k dielectric layer HK may have a uniform thickness. However, the thickness of the interface layer IL may be greater in the horizontal direction than in the vertical direction. Due to this difference in the thickness of the interface layer IL, the first thickness TK1 of the gate insulating layer GI may be greater than the second thickness TK2.

The gate insulating layer GI may include a first region PA1, which is provided on a first facet FA1 of the first source/drain pattern SD1 and has the first thickness TK1. As shown, the first region PA1 of the gate insulating layer GI may directly cover a side surface of the first source/drain pattern SD1. The first facet FA1 of the first source/drain pattern SD1 may be a crystallographic plane (e.g., a first crystallographic plane) normal to the second direction D2. For example, the first facet FA1 may be a {1 1 0} crystallographic plane. In this context, {a b c} represents a crystallographic plane with Miller indices a, b and c.

The gate insulating layer GI may include a second region PA2, which is provided on a second facet FA2 of each of the first and second semiconductor patterns SP1 and SP2 and has the second thickness TK2. The second facet FA2 may be a top surface of the first semiconductor pattern SP1 or a bottom surface of the second semiconductor pattern SP2. The second facet FA2 may be a crystallographic plane (e.g., a second crystallographic plane) normal to the third direction D3. For example, the second facet FA2 may be a {1 0 0} crystallographic plane.

According to some example embodiments of the inventive concepts, in a process of forming the interface layer IL, a formation rate of the interface layer IL may be higher on a {1 1 0} crystallographic plane than on a {1 0 0} crystallographic plane. Thus, a thickness (e.g., TK1) on the {1 1 0} crystallographic plane of the interface layer IL may be greater than a thickness (e.g., TK2) on the {1 0 0} crystallographic plane. According to some example embodiments of the inventive concepts, the gate insulating layer GI may be formed to have the first thickness TK1 on the first facet FA1, which is the {1 1 0} crystallographic plane, and to have the second thickness TK2 on the second facet FA2, which is the {1 0 0} crystallographic plane.

According to some example embodiments of the inventive concepts, since the first thickness TK1 of the first region PA1 of the gate insulating layer GI is greater than the second thickness TK2 of the second region PA2, it may be possible to reduce a leakage current of a transistor in an off-state. Furthermore, it may be possible to reduce a capacitance between the first to third portions PO1, PO2, and PO3 of the gate electrode GE and the first source/drain pattern SD1. That is, according to some example embodiments of the inventive concepts, by selectively increasing the thickness of the gate insulating layer GI, it may be possible to improve the electrical characteristics of the semiconductor device.

For example, the gate electrode GE may include a second portion PO2 that is between the second semiconductor pattern SP2 and another semiconductor pattern (e.g., the first semiconductor pattern SP1), the second portion PO2 of the gate electrode GE may be adjacent to the second semiconductor pattern SP2, the gate insulating layer GI may include comprises a first region PA1 between the second portion PO2 of the gate electrode GE and the first source/drain pattern SD1, which may directly cover a side surface of the first source/drain pattern SD1, and a second region PA2 between the second portion PO2 of the gate electrode GE and the other semiconductor pattern (e.g., between the second portion PO2 and a bottom surface of the second semiconductor pattern SP2), and a thickness of the first region PA1 in a horizontal direction (e.g., second direction D2) that is perpendicular to the vertical direction (e.g., third direction D3) may be greater than a thickness of the second region PA2 region in the vertical direction (e.g., third direction D3).

Referring to FIG. 6B, the first to third semiconductor patterns SP1, SP2, and SP3 may be stacked on the first active pattern AP1 to be vertically spaced apart from each other. The gate insulating layer GI may be provided to enclose each of the first to third semiconductor patterns SP1, SP2, and SP3. Hereinafter, the second semiconductor pattern SP2, which is one of the semiconductor patterns, and the gate insulating layer GI, which is provided to enclose the same, will be described in more detail below.

The gate insulating layer GI may include a third region PA3, which is provided on the side surface (e.g., the first facet FA1) of the second semiconductor pattern SP2. The gate insulating layer GI may include a fourth region PA4, which is provided on a top or bottom surface (e.g., the second facet FA2) of the second semiconductor pattern SP2.

The first facet FA1 may be a crystallographic plane normal to the first direction D1. For example, the first facet FA1 may be the {1 1 0} crystallographic plane. The second facet FA2 may be a crystallographic plane normal to the third direction D3. For example, the second facet FA2 may be the {1 0 0} crystallographic plane. For example, the side surface of the first source/drain pattern SD1 may comprise a {1 1 0} crystallographic plane, and the bottom surface of the second semiconductor pattern SP2 may comprise the {1 0 0} crystallographic plane.

A thickness of the gate insulating layer GI in the horizontal direction (e.g., a thickness of the third region PA3) may be the first thickness TK1. A thickness of the gate insulating layer GI in the vertical direction (e.g., a thickness of the fourth region PA4) may be the second thickness TK2. The first thickness TK1 may be greater than the second thickness TK2.

In some example embodiments, the high-k dielectric layer HK may have a uniform thickness. Nevertheless, the thickness of the interface layer IL may be greater in the horizontal direction than in the vertical direction. Due to this difference in the thickness of the interface layer IL, the first thickness TK1 of the gate insulating layer GI may be greater than the second thickness TK2.

In some example embodiments, since the first thickness TK1 of the third region PA3 of the gate insulating layer GI is greater than the second thickness TK2 of the fourth region PA4, it may be possible to reduce a leakage current of a transistor in an on-state. When the fourth region PA4 of the gate insulating layer GI has a relatively small thickness (e.g., TK2), a space SPA between adjacent ones of the semiconductor patterns SP1-SP3 may be enlarged. In this case, the spaces SPA between the semiconductor patterns SP1-SP3 may be stably filled with the first to third portions PO1 to PO3 of the gate electrode GE. That is, according to some example embodiments of the inventive concepts, by changing the thickness of the gate insulating layer GI, it may be possible to improve the electrical and reliability characteristics of the semiconductor device.

For example, the gate insulating layer GI may include a third region PA3 on one of the opposite side surfaces of the second semiconductor pattern SP2 (e.g., first facets FA1); and a fourth region PA4 on one of the top surface of the second semiconductor pattern SP2 or the bottom surface of the second semiconductor pattern SP2, and the first thickness TK1 of the third region PA3 in the horizontal direction (e.g., first direction D1) may be greater than the second thickness TK2 of the fourth region PA4 in the vertical direction (e.g., third direction D3) that is perpendicular to the horizontal direction. For example, a thickness in the horizontal direction (e.g., first direction D1) of the interface layer IL of the third region PA3 of the gate insulating layer GI may be greater (e.g., greater in magnitude) than a thickness in the vertical direction (e.g., third direction D3) of the interface layer IL of the fourth region PA4 of the gate insulating layer GI. For example, a thickness in the horizontal direction (e.g., first direction D1) of the high-k dielectric layer HK of the third region PA3 of the gate insulating layer GI may be greater (e.g., greater in magnitude) than a thickness in the vertical direction (e.g., third direction D3) of the high-k dielectric layer HK of the fourth region PA4 of the gate insulating layer GI.

The gate insulating layer GI on the first channel pattern CH1 is illustrated in FIGS. 6A and 6B as an example. However, the gate insulating layer GI, which is provided not only on the first channel pattern CH1 but also on the second channel pattern CH2, may have the same features as illustrated in FIGS. 6A and 6B.

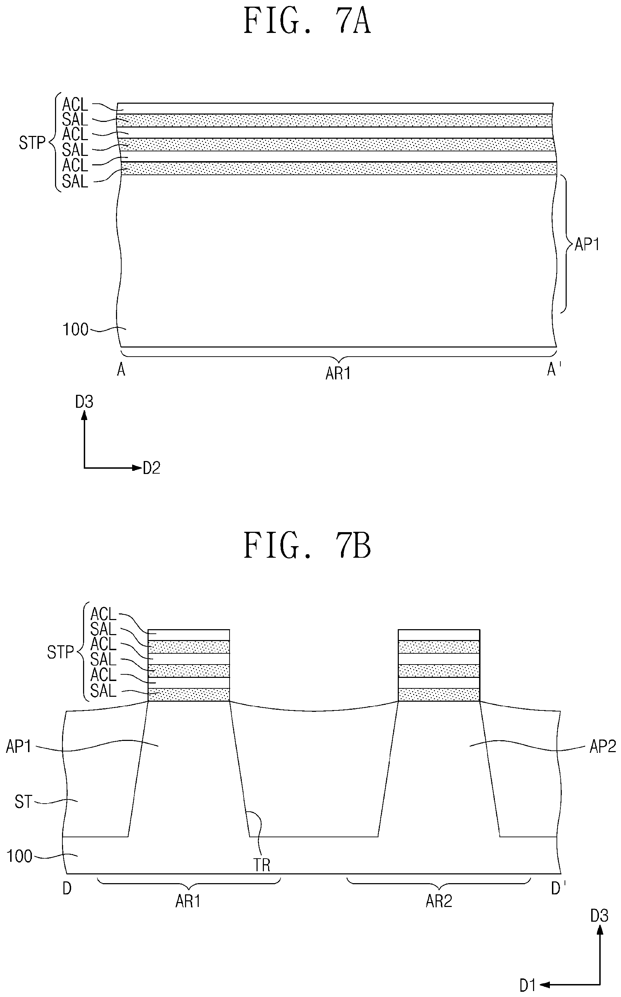

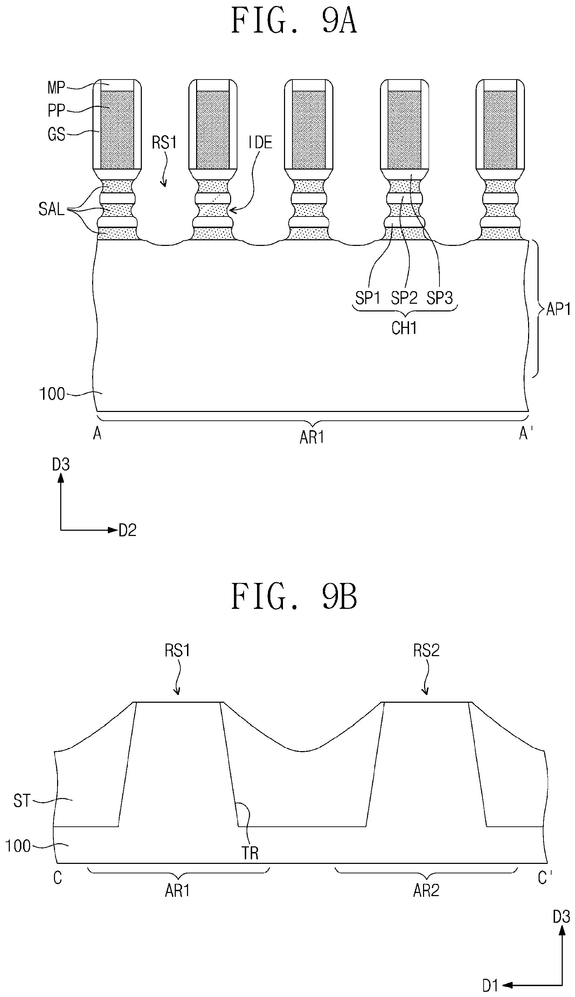

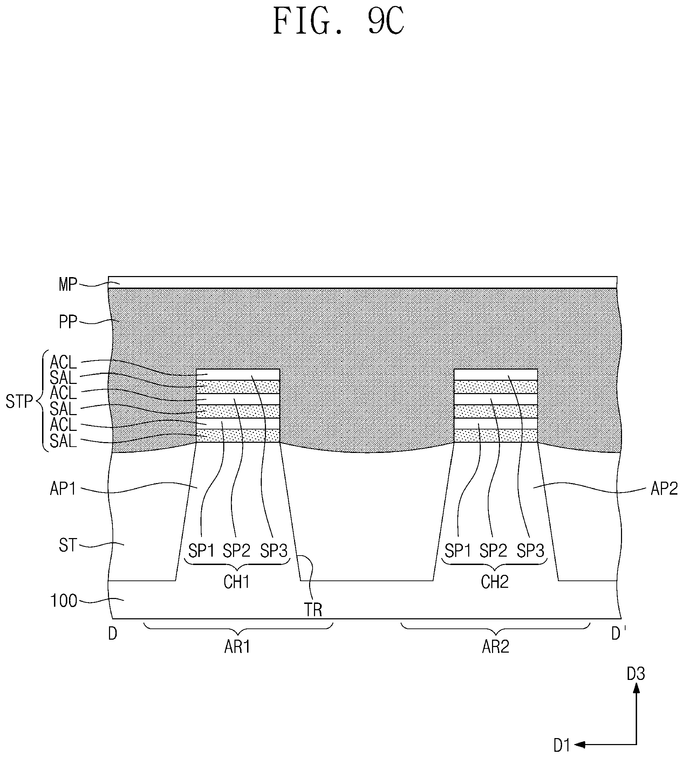

FIGS. 7A, 7B, 8A, 8B, 9A, 9B, 9C, 10A, 10B, 10C, 11A, 11B, 11C, 12A, 12B, and 12C are sectional views illustrating a method of fabricating a semiconductor device, according to some example embodiments of the inventive concepts. In detail, FIGS. 7A, 8A, 9A, 10A, 11A, and 12A are sectional views corresponding to the line A-A' of FIG. 4. FIGS. 9B, 10B, 11B, and 12B are sectional views corresponding to the line C-C' of FIG. 4. FIGS. 7B, 8B, 9C, 10C, 11C, and 12C are sectional views corresponding to the line D-D' of FIG. 4.

Referring to FIGS. 7A and 7B, the substrate 100 including the first and second active regions AR1 and AR2 may be provided. Active layers ACL and sacrificial layers SAL may be alternately stacked on the substrate 100. The active layers ACL may be formed of or include one of silicon (Si), germanium (Ge), and silicon germanium (SiGe), and the sacrificial layers SAL may be formed of or include another one of silicon (Si), germanium (Ge), and silicon germanium (SiGe).

The sacrificial layer SAL may be formed of or include a material having an etch selectivity with respect to the active layer ACL. For example, the active layers ACL may be formed of or include silicon (Si), and the sacrificial layers SAL may be formed of or include silicon germanium (SiGe). A germanium concentration of each of the sacrificial layers SAL may range from 10 at% to 30 at%.

Mask patterns may be respectively formed on the first and second active regions AR1 and AR2 of the substrate 100. The mask pattern may be a line- or bar-shaped pattern that is extended in the second direction D2.

A patterning process using the mask patterns as an etch mask may be performed to form the trench TR defining the first and second active patterns AP1 and AP2. The first active pattern AP1 may be formed on the first active region AR1. The second active pattern AP2 may be formed on the second active region AR2.

A stacking pattern STP may be formed on each of the first and second active patterns AP1 and AP2. The stacking pattern STP may include the active layers ACL and the sacrificial layers SAL which are alternately stacked. The stacking pattern STP may be formed along with the first and second active patterns AP1 and AP2, during the patterning process.

The device isolation layer ST may be formed to fill the trench TR. In detail, an insulating layer may be formed on the substrate 100 to cover the first and second active patterns AP1 and AP2 and the stacking patterns STP. The device isolation layer ST may be formed by recessing the insulating layer to expose the stacking patterns STP.

The device isolation layer ST may be formed of or include at least one of insulating materials (e.g., silicon oxide). The stacking patterns STP may be placed above the device isolation layer ST and may be exposed to the outside of the device isolation layer ST. In other words, the stacking patterns STP may protrude vertically above the device isolation layer ST.

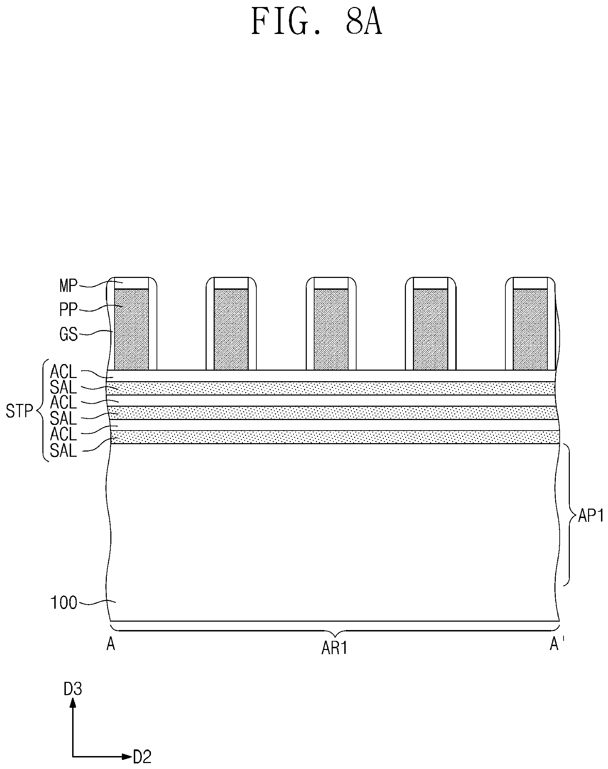

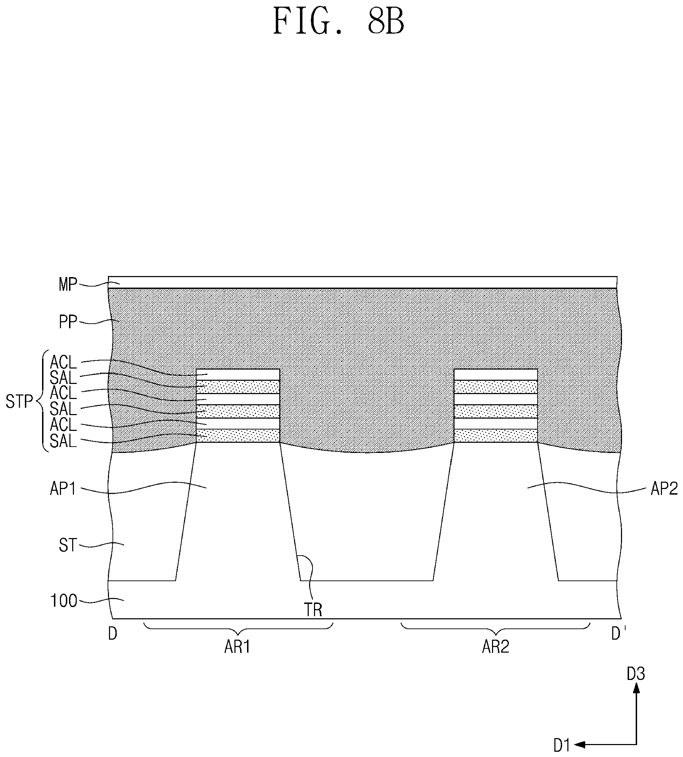

Referring to FIGS. 8A and 8B, sacrificial patterns PP may be formed on the substrate 100 to cross the stacking patterns STP. Each of the sacrificial patterns PP may be a line- or bar-shaped pattern that is extended in the first direction D1. The sacrificial patterns PP may be arranged at a first pitch in the second direction D2.

In detail, the formation of the sacrificial patterns PP may include forming a sacrificial layer on the substrate 100, forming hard mask patterns MP on the sacrificial layer, and patterning the sacrificial layer using the hard mask patterns MP as an etch mask. The sacrificial layer may be formed of or include polysilicon.

A pair of the gate spacers GS may be formed on opposite side surfaces of each of the sacrificial patterns PP. The formation of the gate spacers GS may include conformally forming a gate spacer layer on the substrate 100 and anisotropically etching the gate spacer layer. In some example embodiments, the gate spacer GS may be a multi-layered structure including at least two layers.

Referring to FIGS. 9A to 9C, the first recesses RS1 may be formed in the stacking pattern STP on the first active pattern AP1. The second recesses RS2 may be formed in the stacking pattern STP on the second active pattern AP2. During the formation of the first and second recesses RS1 and RS2, the device isolation layer ST may also be recessed at both sides of each of the first and second active patterns AP1 and AP2 (e.g., see FIG. 9B).

In detail, the first recesses RS1 may be formed by etching the stacking pattern STP on the first active pattern AP1 using the hard mask patterns MP and the gate spacers GS as an etch mask. The first recess RS1 may be formed between a pair of the sacrificial patterns PP. The formation of the first recess RS1 may further include performing a selective etching process on the sacrificial layers SAL exposed. Each of the sacrificial layers SAL may be indented by the selective etching process to form an indent region IDE. Thus, the first recess RS1 may have a wavy inner side surface. The second recesses RS2 in the stacking pattern STP on the second active pattern AP2 may be formed by the same method as that for the first recesses RS1.

The first to third semiconductor patterns SP1, SP2, and SP3, which are sequentially stacked between adjacent ones of the first recesses RS1, may be respectively formed from the active layers ACL. The first to third semiconductor patterns SP1, SP2, and SP3 between the adjacent ones of the first recesses RS1 may constitute the first channel pattern CH1. The first to third semiconductor patterns SP1, SP2, and SP3 between adjacent ones of the second recesses RS2 may constitute the second channel pattern CH2.

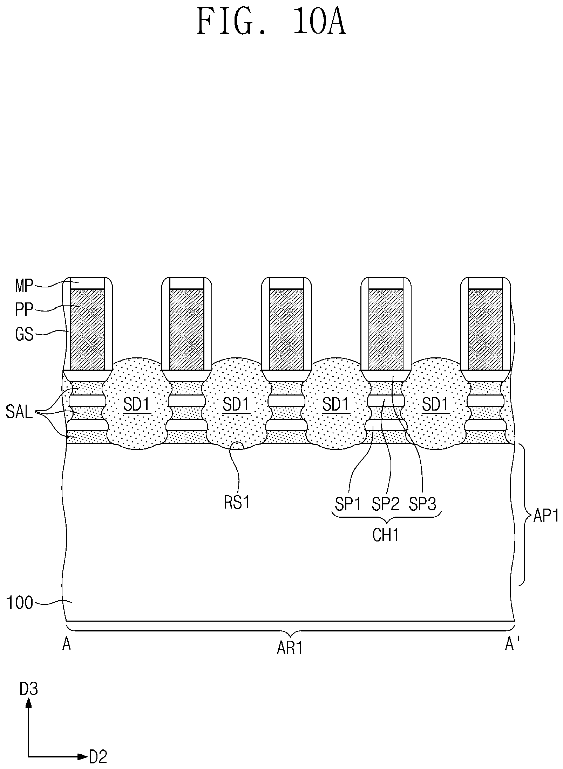

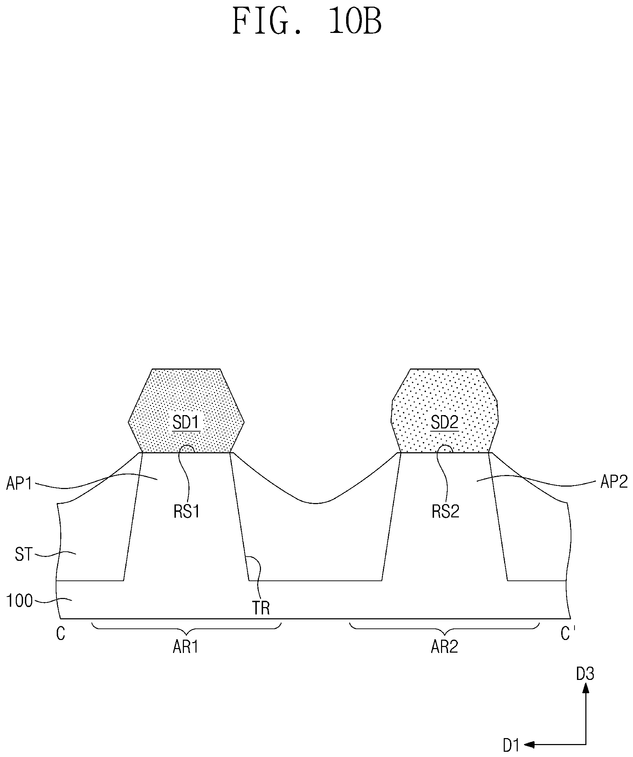

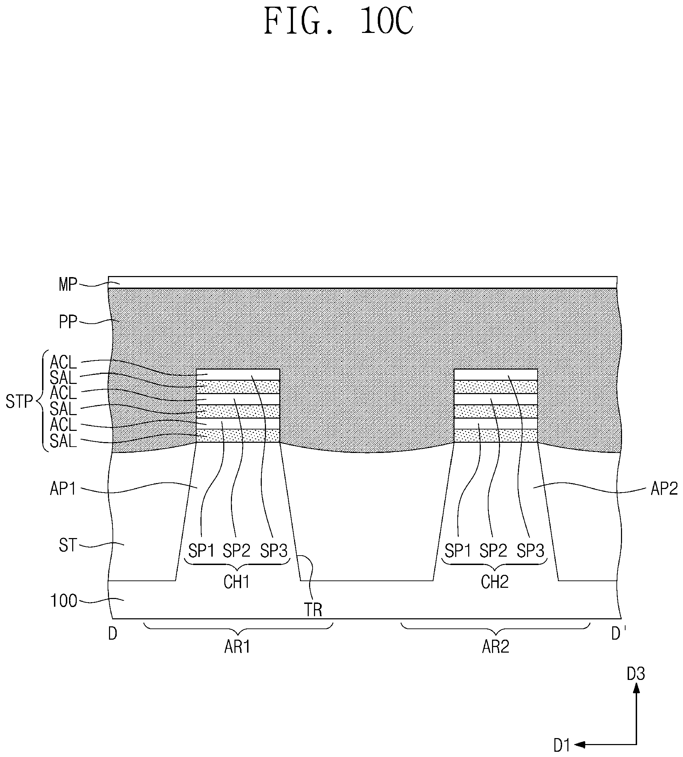

Referring to FIGS. 10A to 10C, the first source/drain patterns SD1 may be formed in the first recesses RS1, respectively. In detail, a selective epitaxial growth (SEG) process, in which an inner surface of the first recess RS1 is used as a seed layer, may be performed to form an epitaxial layer filling the first recess RS1. The epitaxial layer may be grown using the first to third semiconductor patterns SP1, SP2, and SP3 and the substrate 100, which are exposed by the first recess RS1, as the seed layer. In some example embodiments, the SEG process may include a chemical vapor deposition (CVD) process or a molecular beam epitaxy (MBE) process.

In some example embodiments, the first source/drain pattern SD1 may be formed of or include the same semiconductor element (e.g., Si) as the substrate 100. During the formation of the first source/drain pattern SD1, the first source/drain pattern SD1 may be doped in-situ with n-type impurities (e.g., phosphorus, arsenic, or antimony). Alternatively, impurities may be injected into the first source/drain pattern SD1, after the formation of the first source/drain pattern SD1.

The second source/drain patterns SD2 may be formed in the second recesses RS2, respectively. In detail, the second source/drain pattern SD2 may be formed by a SEG process using an inner surface of the second recess RS2 as a seed layer.

In some example embodiments, the second source/drain pattern SD2 may be formed of or include a semiconductor material (e.g., SiGe) whose lattice constant is greater than that of a semiconductor material of the substrate 100. During the formation of the second source/drain pattern SD2, the second source/drain pattern SD2 may be doped in-situ with p-type impurities (e.g., boron, gallium, or indium). Alternatively, impurities may be injected into the second source/drain pattern SD2, after the formation of the second source/drain pattern SD2.

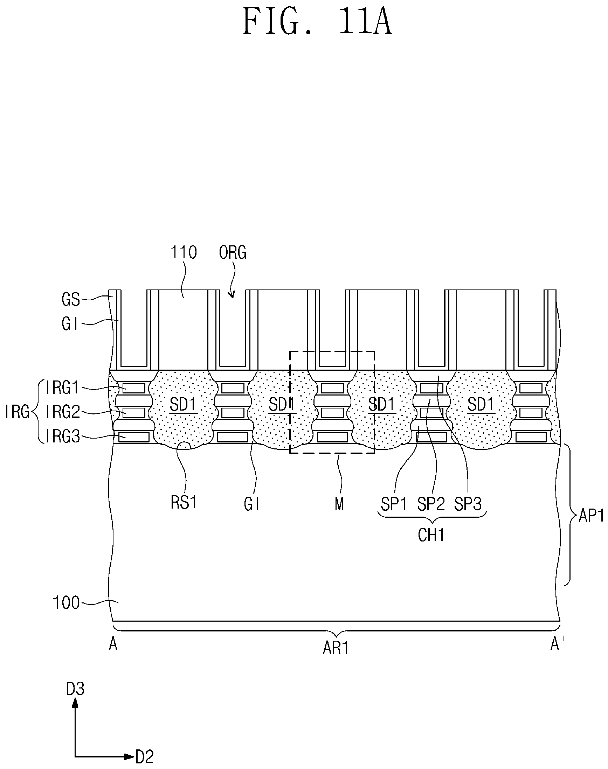

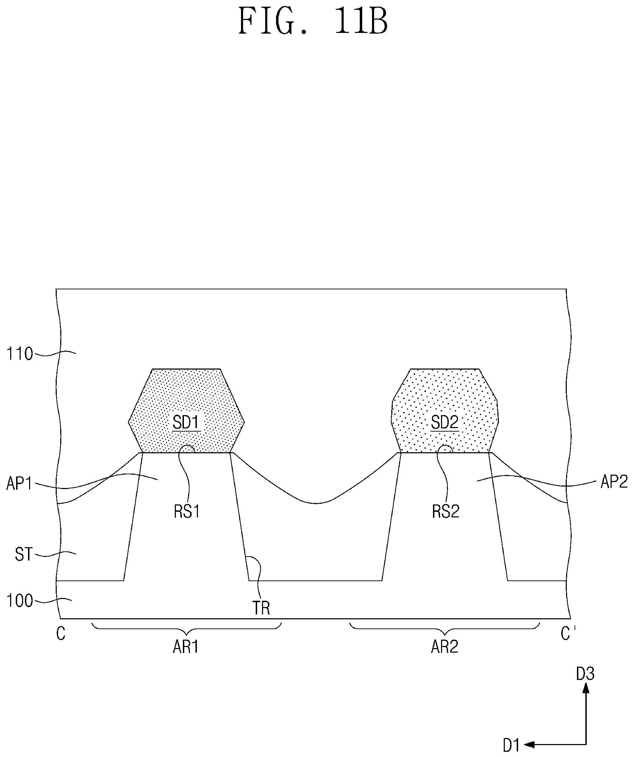

Referring to FIGS. 11A to 11C, the first interlayer insulating layer 110 may be formed to cover the first and second source/drain patterns SD1 and SD2, the hard mask patterns MP, and the gate spacers GS. In some example embodiments, the first interlayer insulating layer 110 may include a silicon oxide layer.

The first interlayer insulating layer 110 may be planarized to expose the top surfaces of the sacrificial patterns PP. The planarization of the first interlayer insulating layer 110 may be performed using an etch-back or chemical-mechanical polishing (CMP) process. All of the hard mask patterns MP may be removed during the planarization process. As a result, the first interlayer insulating layer 110 may have a top surface that is substantially coplanar the top surfaces of the sacrificial patterns PP and the top surfaces of the gate spacers GS.

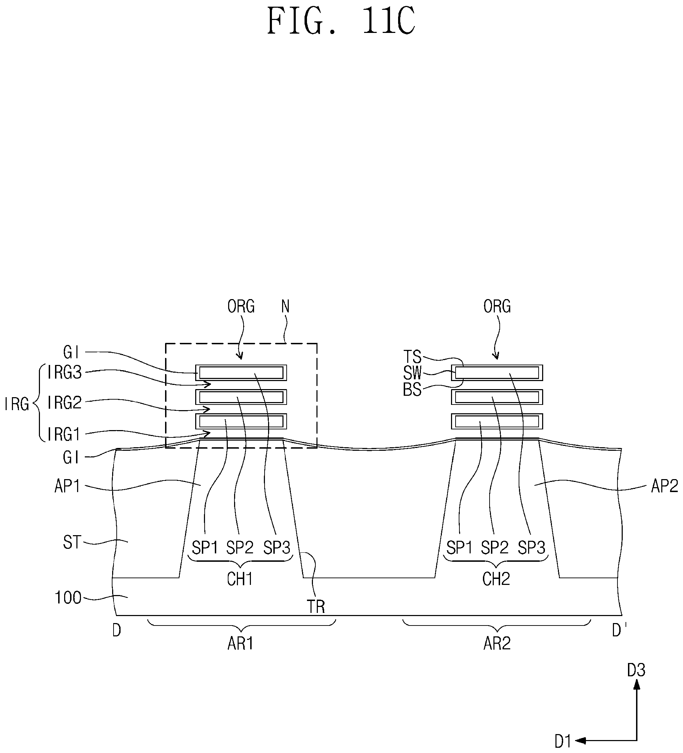

The exposed sacrificial patterns PP may be selectively removed. As a result of the removal of the sacrificial patterns PP, an outer region ORG exposing the first and second channel patterns CH1 and CH2 may be formed (e.g., see FIG. 11C). The removal of the sacrificial patterns PP may include a wet etching process which is performed using etching solution capable of selectively etching polysilicon.

The sacrificial layers SAL exposed through the outer region ORG may be selectively removed to form inner regions IRG (e.g., see FIG. 11C). In detail, a process of selectively etching the sacrificial layers SAL may be performed to leave the first to third semiconductor patterns SP1, SP2, and SP3 and to remove only the sacrificial layers SAL. The etching process may be chosen to have a high etch rate for a material (e.g., SiGe) having a relatively high germanium concentration. For example, the etching process may be chosen to have a high etch rate for a silicon germanium layer whose germanium concentration is higher than 10 at%.

During the etching process, the sacrificial layers SAL on the first and second active regions AR1 and AR2 may be removed. The etching process may be a wet etching process. An etchant material, which is used in the etching process, may be chosen to quickly remove the sacrificial layer SAL having a relatively high germanium concentration.

Referring back to FIG. 11C, since the sacrificial layers SAL are selectively removed, only the stacked first to third semiconductor patterns SP1, SP2, and SP3 may be left on each of the first and second active patterns AP1 and AP2. As a result of the removal of the sacrificial layers SAL, first to third inner regions IRG1, IRG2, and IRG3 may be formed on each of the first and second active patterns AP1 and AP2.

In detail, the first inner region IRG1 may be formed between the active pattern AP1 or AP2 and the first semiconductor pattern SP1, the second inner region IRG2 may be formed between the first semiconductor pattern SP1 and the second semiconductor pattern SP2, and the third inner region IRG3 may be formed between the second semiconductor pattern SP2 and the third semiconductor pattern SP3.

Referring back to FIGS. 11A to 11C, the gate insulating layer GI may be formed to cover exposed surfaces of the first to third semiconductor patterns SP1, SP2, and SP3. The gate insulating layer GI may be formed to enclose each of the first to third semiconductor patterns SP1, SP2, and SP3.

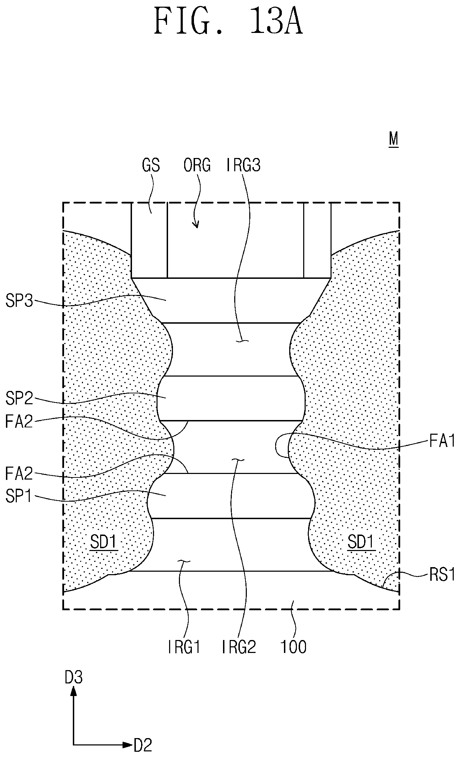

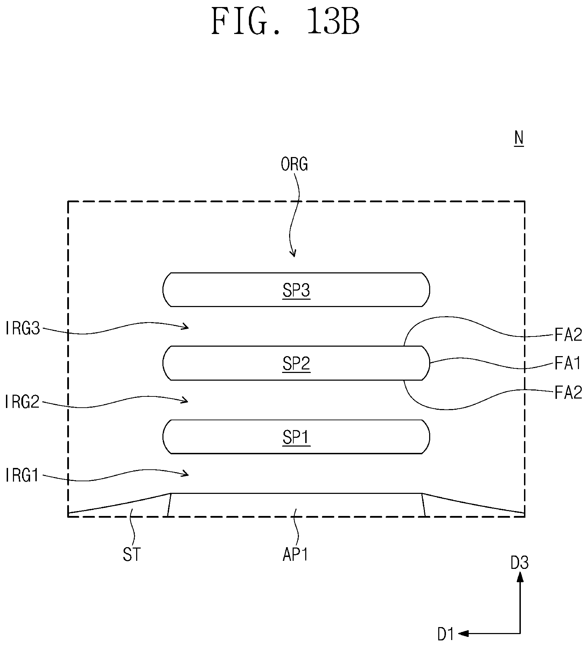

FIGS. 13A, 14A, and 15A are enlarged sectional views illustrating a method of forming a portion 'M' of FIG. 11A. FIGS. 13B, 14B, and 15B are enlarged sectional views illustrating a method of forming a portion 'N' of FIG. 11C.

Referring to FIGS. 13A and 13B, the outer region ORG may be formed by selectively removing the sacrificial pattern PP, as described above. The first to third inner regions IRG1 to IRG3 may be formed by selectively removing the sacrificial layers SAL exposed through the outer region ORG.

Referring to FIG. 13A, as a representative example, the second inner region IRG2 may expose the first facet FA1 of the first source/drain pattern SD1. The second inner region IRG2 may expose the second facets FA2 of the first and second semiconductor patterns SP1 and SP2. The first facet FA1 may be a crystallographic plane whose normal is parallel to a top surface of the substrate 100. For example, the first facet FA1 may be a {1 1 0} crystallographic plane. The second facet FA2 may be a crystallographic plane whose normal is perpendicular to the top surface of the substrate 100. For example, the second facet FA2 may be a {1 0 0} crystallographic plane.

Referring to FIG. 13B, for the second semiconductor pattern SP2 as a representative example, a top surface, a bottom surface, and opposite side surfaces may be exposed. Each of the opposite side surfaces of the second semiconductor pattern SP2 may be the first facet FA1. Each of the top and bottom surfaces of the second semiconductor pattern SP2 may be the second facet FA2.

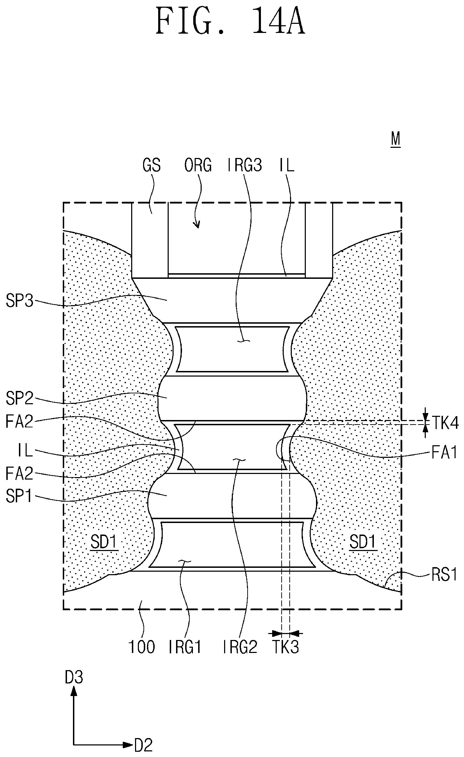

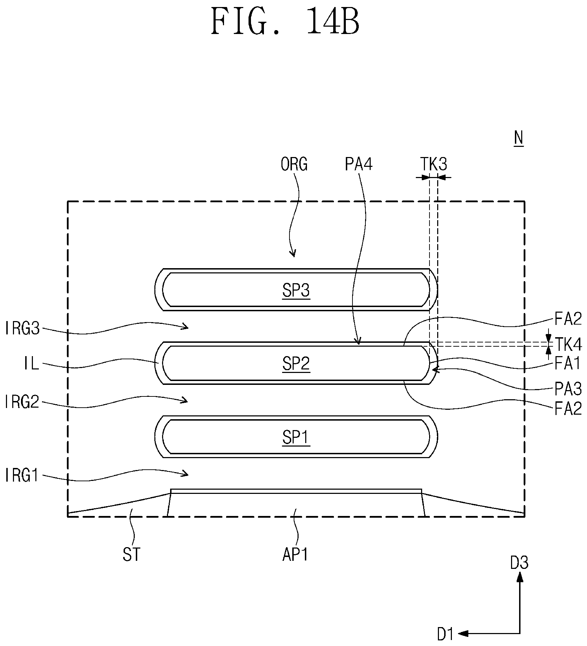

Referring to FIGS. 14A and 14B, the interface layer IL may be formed in the outer region ORG and the first to third inner regions IRG1-IRG3. The interface layer IL may be selectively formed on the semiconductor crystallographic plane exposed by the outer region ORG and the first to third inner regions IRG1-IRG3. In some example embodiments, the interface layer IL may not be formed on the gate spacer GS. In some example embodiments, the interface layer IL may also be formed on the gate spacer GS.

The interface layer IL on the first facet FA1 may have a third thickness TK3, and the interface layer IL on the second facet FA2 may have a fourth thickness TK4. The third thickness TK3 may be greater than the fourth thickness TK4. In other words, the interface layer IL may be formed to have a thickness that depends on a crystal orientation of the semiconductor crystallographic plane.

In some example embodiments, the process of forming the interface layer IL may be controlled such that a formation rate of the interface layer IL is higher on the first facet FA1 or the {1 1 0} crystallographic plane than on the second facet FA2 or the {1 0 0} crystallographic plane. In other words, the formation rate of the interface layer IL in the horizontal direction may be controlled to be higher than the formation rate of the interface layer IL in the vertical direction. Thus, the third thickness TK3 of the interface layer IL may have a value that is greater than the fourth thickness TK4.

The process of forming the interface layer IL may include a semiconductor oxidation process and/or an oxide deposition process. As described above, the process of forming the interface layer IL may be controlled to have a difference between the formation speeds in horizontal and vertical directions.

In the present specification, the term "formation rate" or "formation speeds" may mean a growth rate or a deposition rate of the interface layer IL in the process of forming the interface layer IL. As an example, if the interface layer IL is formed by the semiconductor oxidation process, the formation rate of the interface layer IL may mean the growth rate. As another example, if the interface layer IL is formed by the oxide deposition process, the formation rate of the interface layer IL may mean the deposition rate.

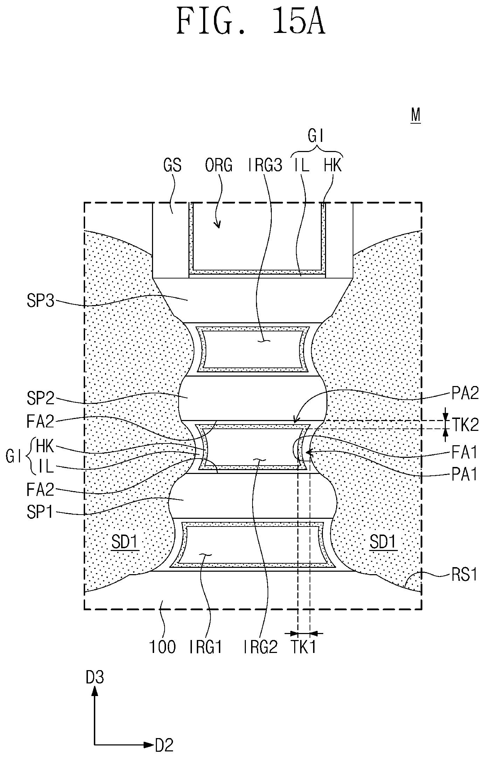

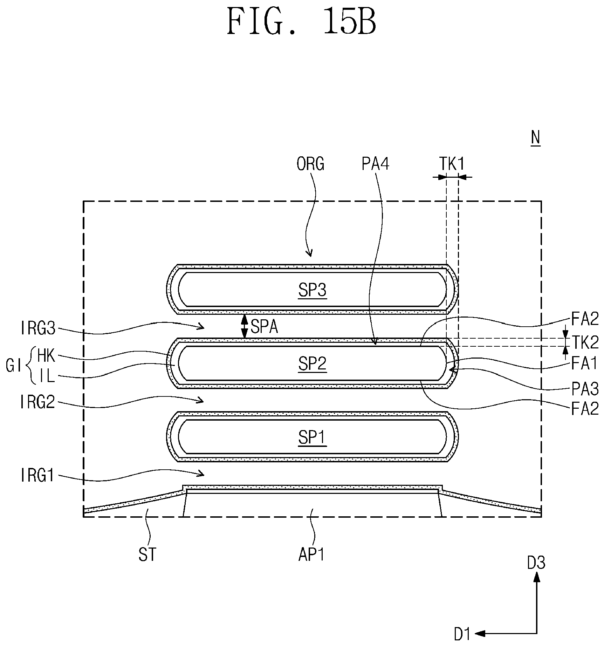

Referring to FIGS. 15A and 15B, the high-k dielectric layer HK may be formed in the outer region ORG and the first to third inner regions IRG1-IRG3. The high-k dielectric layer HK may be formed on the interface layer IL. The interface layer IL and the high-k dielectric layer HK may form the gate insulating layer GI.

In some example embodiments, the high-k dielectric layer HK may be formed conformally. In other words, a thickness of the high-k dielectric layer HK in a horizontal direction may be equal to a thickness in a vertical direction.

In some example embodiments, the process of forming the high-k dielectric layer HK may be controlled such that a formation rate of the high-k dielectric layer HK is higher in the horizontal direction than in the vertical direction. In this case, the high-k dielectric layer HK may be formed such that a thickness in the horizontal direction is greater than that in the vertical direction.

According to some example embodiments of the inventive concepts, a thickness TK1 of the gate insulating layer GI on the first facet FA1 may be greater than a thickness TK2 of the gate insulating layer GI on the second facet FA2. In other words, the thickness TK1 of the gate insulating layer GI in the horizontal direction may be greater than the thickness TK2 in the vertical direction. Accordingly, it may be possible to reduce a leakage current of a transistor and to improve the electrical characteristics of the semiconductor device.

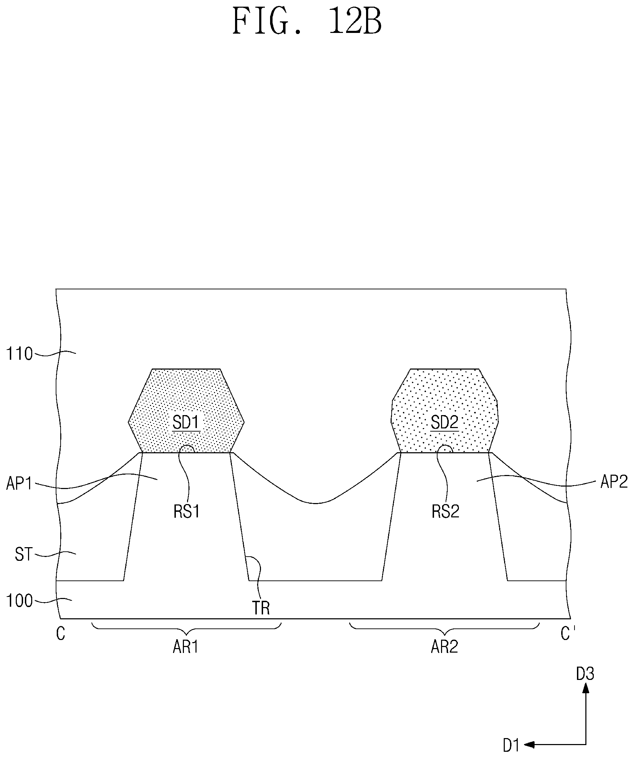

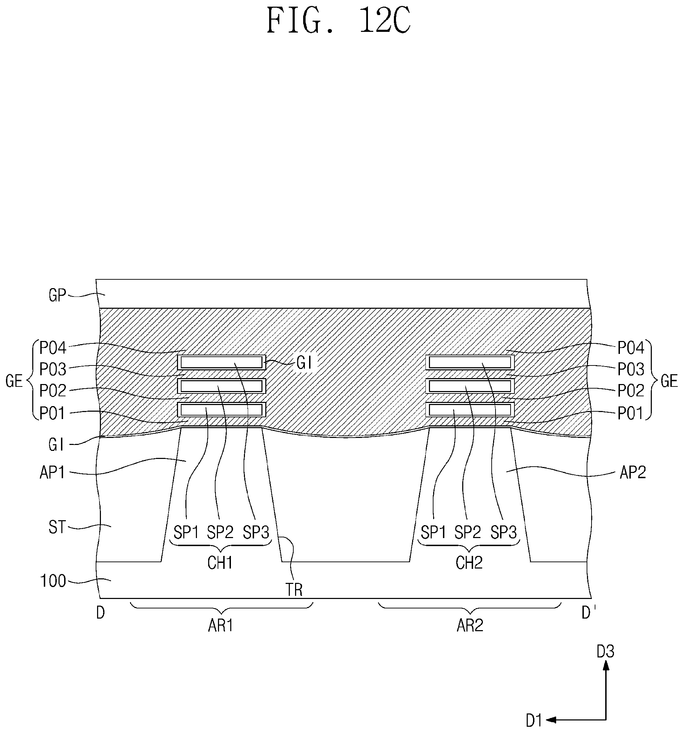

Meanwhile, since, as illustrated in FIG. 15B, the thickness TK2 of the gate insulating layer GI in the vertical direction has a relatively small value, the space SPA in each of the first to third inner regions IRG1, IRG2, and IRG3 may be formed to have a thickness greater than a value required for the formation of the gate electrode GE. This may make it possible to reduce a difficulty in filling the space SPA with the first to third portions PO1, PO2, and PO3 of the gate electrode GE of FIG. 12C.

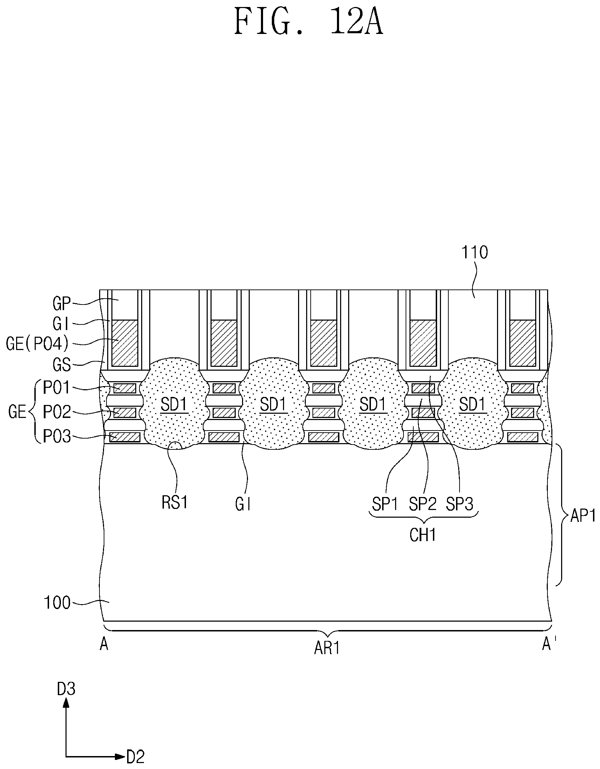

Referring to FIGS. 12A to 12C, the gate electrode GE may be formed on the gate insulating layer GI. The gate electrode GE may include the first to third portions PO1, PO2, and PO3, which are respectively formed in the first to third inner regions IRG1, IRG2, and IRG3, and the fourth portion PO4, which is formed in the outer region ORG. The gate electrode GE may be vertically recessed to have a reduced height. The gate capping pattern GP may be formed on the recessed gate electrode GE.

Referring back to FIGS. 5A to 5D, the second interlayer insulating layer 120 may be formed on the first interlayer insulating layer 110. The second interlayer insulating layer 120 may include a silicon oxide layer. The active contacts AC may be formed to penetrate the second interlayer insulating layer 120 and the first interlayer insulating layer 110 and to be electrically connected to the first and second source/drain patterns SD1 and SD2. The gate contact GC may be formed to penetrate the second interlayer insulating layer 120 and the gate capping pattern GP and to be electrically connected to the gate electrode GE.

The formation of each of the active and gate contacts AC and GC may include forming the barrier pattern BM and forming the conductive pattern FM on the barrier pattern BM. The barrier pattern BM may be conformally formed and may include a metal layer and a metal nitride layer. The conductive pattern FM may be formed of or include a low resistance metal.

The division structures DB may be respectively formed on the first and second borders BD1 and BD2 of the single height cell SHC. The division structure DB may penetrate the second interlayer insulating layer 120 and the gate electrode GE and may be extended into the active pattern AP1 or AP2. The division structure DB may be formed of or include an insulating material (e.g., silicon oxide or silicon nitride).

The third interlayer insulating layer 130 may be formed on the active contacts AC and the gate contacts GC. The first metal layer M1 may be formed in the third interlayer insulating layer 130. The fourth interlayer insulating layer 140 may be formed on the third interlayer insulating layer 130. The second metal layer M2 may be formed in the fourth interlayer insulating layer 140.

Some embodiments of the inventive concepts will be further described below. In the following description of these embodiments, an element previously described with reference to FIGS. 6A and 6B may be identified by the same reference number without repeating an overlapping description thereof, for concise description.

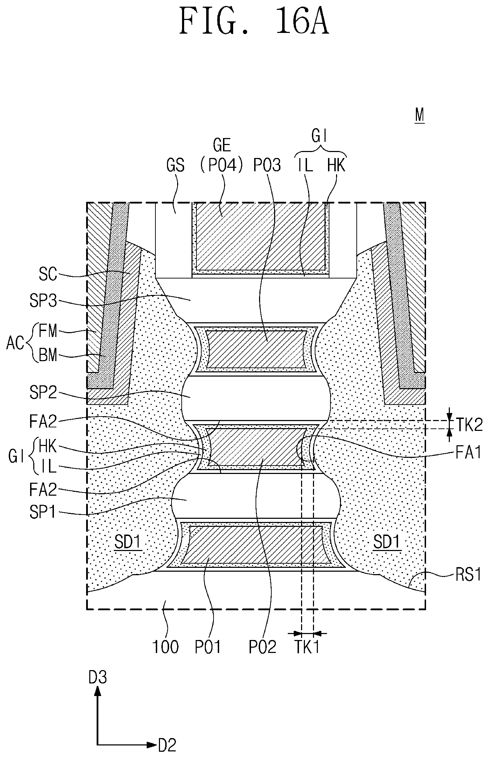

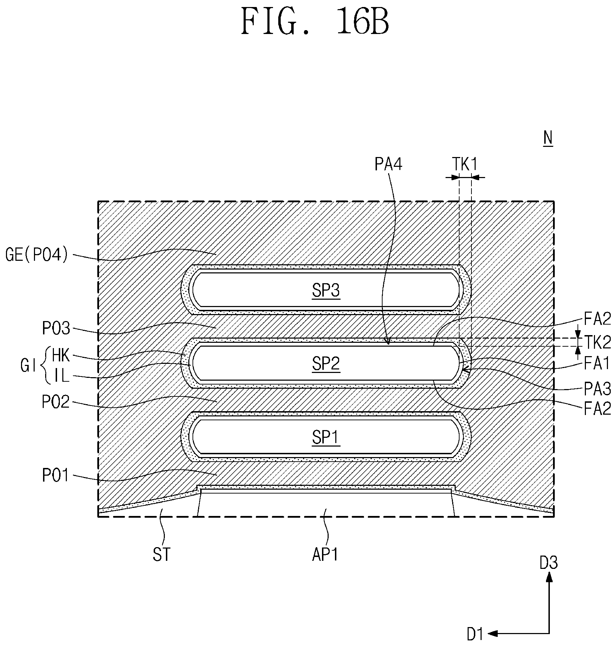

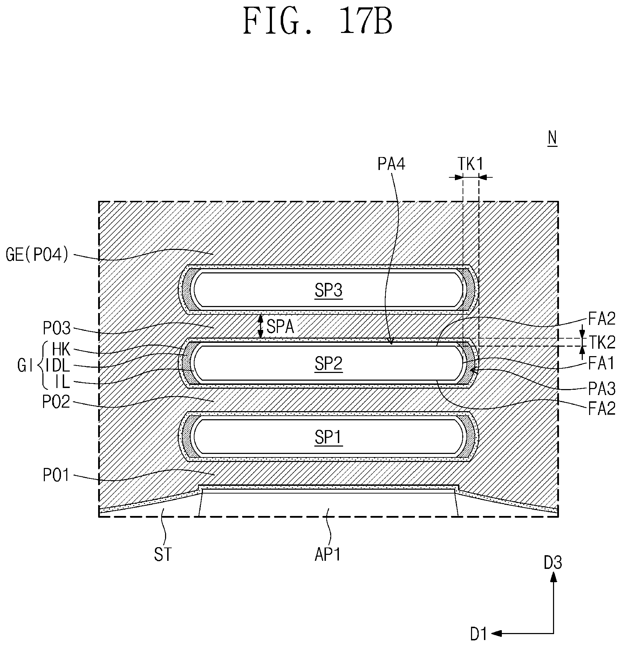

FIGS. 16A, 17A, and 18 are enlarged sectional views, each of which illustrates the portion 'M' of FIG. 5A according to some example embodiments of the inventive concepts. FIGS. 16B and 17B are enlarged sectional views, each of which illustrates the portion 'N' of FIG. 5D according to some example embodiments of the inventive concepts.

Referring to FIGS. 16A and 16B, a thickness of the high-k dielectric layer HK may be greater in a horizontal direction than in a vertical direction. For example, a thickness of the high-k dielectric layer HK on the first facet FA1 may be greater than a thickness of the high-k dielectric layer HK on the second facet FA2. Due to this difference in the thickness of the high-k dielectric layer HK, the first thickness TK1 of the gate insulating layer GI may have a value that is greater than the second thickness TK2.

In some example embodiments, the interface layer IL may have a uniform thickness. In some example embodiments, the thickness of the interface layer IL may also be greater in the horizontal direction than in the vertical direction, as illustrated in FIGS. 6A and 6B.

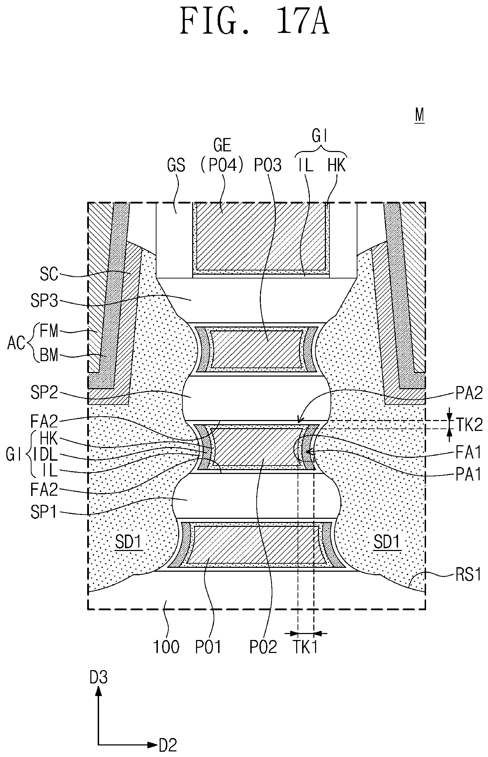

Referring to FIGS. 17A and 17B, the gate insulating layer GI may further include an intermediate layer IDL interposed between the interface layer IL and the high-k dielectric layer HK. The intermediate layer IDL may be selectively formed on the first facet FA1 but not on the second facet FA2, for example such that the second facet FA2 is exposed by the intermediate layer IDL, for example such that the interface layer IL and the high-k dielectric layer HK are in direct contact with each other in the third direction D3 in the region of the gate insulating layer GI in which the intermediate layer is omitted. For example, the gate insulating layer GI on the second facet FA2 may include the interface layer IL and the high-k dielectric layer HK, but not the intermediate layer IDL. Thus, the first thickness TK1 of the gate insulating layer GI may have a value that is greater than the second thickness TK2.

The intermediate layer IDL may be formed of or include a low-k dielectric material whose dielectric constant is lower than the high-k dielectric layer HK. For example, the intermediate layer IDL may include a silicon nitride layer or a silicon oxynitride layer. When comparing dielectric constants, the same test parameters may be utilized (e.g. the same temperature and frequency, e.g. as measured at room temperature (e.g. 293 K) for low (e.g. less than 1kHz) frequencies).

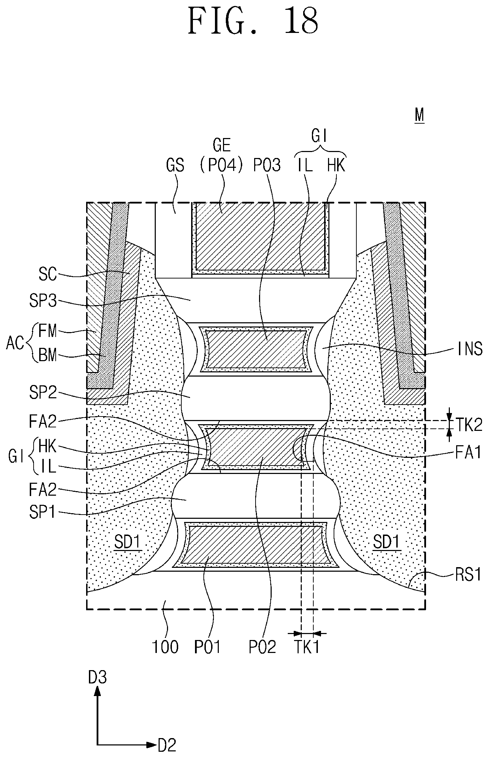

Referring to FIG. 18, inner spacers INS may be respectively interposed between the first to third portions PO1, PO2, and PO3 of the gate electrode GE and the first source/drain pattern SD1. The inner spacers INS may be in direct contact with the first source/drain pattern SD1. Each of the first to third portions PO1, PO2, and PO3 of the gate electrode GE may be spaced apart from the first source/drain pattern SD1 by the inner spacer INS. The inner spacer INS may include a silicon oxide layer, a silicon nitride layer, or a silicon oxynitride layer.

The present description directional terms such as "top", "bottom", "upper", "lower", "above", "below" etc. It will be appreciated that these terms are relative, and need not indicate an orientation of the device in use. For instance, the top surface 100s of the substrate 100 may be the surface upon which the device isolation layer ST is provided. A bottom surface of the substrate may be an opposite surface of the substrate 100. Features that are "above" other features may be further away from the top surface 100s of the substrate 100, along the third direction D3. Similarly, features that are below other features may be closer to the top surface 100s of the substrate 100. Nevertheless, it will be appreciated that the semiconductor memory device could be oriented in any arrangement in use (e.g. so that "upper" features are positioned "below" "lower" features in a different frame of reference).

In a three-dimensional field effect transistor according to some example embodiments of the inventive concepts, a thickness of a gate insulating layer may be greater in a horizontal direction than in a vertical direction. Accordingly, it may be possible to reduce a leakage current of a transistor in both of on- and off-states. In addition, a capacitance between a gate electrode and a source/drain pattern may be reduced. As a result, it may be possible to provide a semiconductor device having improved electrical characteristics according to some example embodiments of the inventive concepts.

While example embodiments of the inventive concepts have been particularly shown and described, it will be understood by one of ordinary skill in the art that variations in form and detail may be made therein without departing from the scope of the attached claims.

## Claims

1. A semiconductor device, comprising:
a substrate (100) including an active pattern (AP1);
a channel pattern (CH1) on the active pattern (AP1), the channel pattern (CH1) including a plurality of semiconductor patterns (SP1, SP2, SP3) vertically stacked to be spaced apart from each other;
a source/drain pattern (SD1) connected to the plurality of semiconductor patterns (SP1, SP2, SP3);
a gate electrode (GE) on the plurality of semiconductor patterns (SP1, SP2, SP3), the gate electrode (GE) extending in a first direction that is parallel to a top surface of the substrate (100); and
a gate insulating layer (GI) between the plurality of semiconductor patterns (SP1, SP2, SP3) and the gate electrode (GE),
wherein a first semiconductor pattern (SP1) of the plurality of semiconductor patterns (SP1, SP2, SP3) includes opposite side surfaces, which are opposite to each other in the first direction, a bottom surface, and a top surface,
wherein the gate insulating layer (GI) covers the opposite side surfaces of the first semiconductor pattern (SP1), the bottom surface of the first semiconductor pattern (SP1), and the top surface of the first semiconductor pattern (SP1),
wherein the gate insulating layer (GI) includes:
a first region (PA1) on one of the opposite side surfaces of the first semiconductor pattern (SP1); and
a second region (PA2) on one of the top surface of the first semiconductor pattern (SP1) or the bottom surface of the first semiconductor pattern (SP1), and
a first thickness (TK1) of the first region (PA1) in the first direction is greater than a second thickness (TK2) of the second region (PA2) in a second direction that is perpendicular to the top surface of the substrate (100), wherein a ratio (TK2/TK1) of the second thickness (TK2) to the first thickness (TK1) falls within the range of 0.3 to 0.8.

2. The semiconductor device of claim 1, wherein the gate insulating layer (GI) comprises:
an interface layer (IL) which directly covers the first semiconductor pattern (SP1), and
a high-k dielectric layer (HK) which is on the interface layer (IL).

3. The semiconductor device of claim 2, wherein a thickness in the first direction of the interface layer (IL) of the first region (PA1) is greater than a thickness in the second direction of the interface layer (IL) of the second region (PA2).

4. The semiconductor device of claim 2 or claim 3, wherein a thickness in the first direction of the high-k dielectric layer (HK) of the first region (PA1) is greater than a thickness in the second direction of the high-k dielectric layer (HK) of the second region (PA2).

5. The semiconductor device of any of claims 2-4, wherein
the gate insulating layer (GI) further comprises an intermediate layer (IDL) between the interface layer (IL) and the high-k dielectric layer (HK), and
the intermediate layer (IDL) is selectively on the first region (PA1) such that the second region (PA2) is exposed by the intermediate layer (IDL).

6. The semiconductor device of claim 5, wherein
the one of the opposite side surfaces of the first semiconductor pattern (SP1) comprises a first crystallographic plane that is normal to the first direction, and
the one of the top surface of the first semiconductor pattern (SP1) or the bottom surface of the first semiconductor pattern (SP1) comprises a second crystallographic plane that is normal to the second direction.

7. The semiconductor device of claim 6, wherein
the first crystallographic plane is a {1 1 0} crystallographic plane, and
the second crystallographic plane is a {1 0 0} crystallographic plane.

8. The semiconductor device of any preceding claim, wherein
the gate electrode (GE) comprises a portion (PO2) that is between the first semiconductor pattern (SP1) and a second semiconductor pattern (SP2),
the portion (PO2) of the gate electrode (GE) is adjacent to the second semiconductor pattern (SP2),
the gate insulating layer (GI) comprises a third region (PA1) between the portion (PO2) of the gate electrode (GE) and the source/drain pattern (SD1) and a fourth region (PA2) between the portion (PO2) of the gate electrode (GE) and the second semiconductor pattern (SP2), and
a thickness of the third region (PA1) perpendicular to the second direction is greater than a thickness of the fourth region (PA2) in the second direction.

9. The semiconductor device of claim 8, wherein the third region (PA1) of the gate insulating layer (GI) directly covers a side surface of the source/drain pattern (SD1).

10. The semiconductor device of claim 9, wherein
the source/drain pattern (SD1) comprises a protruding portion protruding toward the portion of the gate electrode (GE), and
the side surface (SW) of the source/drain pattern (SD1) has a wavy profile such that a position of the side surface (SW) oscillates perpendicularly to the second direction as the side surface (SW) of the source/drain pattern (SD1) extends in the second direction.

11. A method of fabricating a semiconductor device, the method comprising:
forming a stacking pattern on a substrate (100), the stacking pattern including active layers and sacrificial layers, which are alternately stacked;
forming a sacrificial pattern, which is extended in a first direction extending in parallel to a top surface of the substrate (100), on the stacking pattern;
etching the stacking pattern, which is adjacent to a side of the sacrificial pattern, to form a recess;
forming a source/drain pattern (SD1) in the recess, the active layers connected to the source/drain pattern (SD1) forming semiconductor patterns constituting a channel pattern;
removing the sacrificial pattern and the sacrificial layers to expose the semiconductor patterns; and
sequentially forming a gate insulating layer (GI) and a gate electrode (GE) on the exposed semiconductor patterns,
wherein a first semiconductor pattern (SP1) of the semiconductor patterns includes opposite side surfaces, which are opposite to each other in the first direction, a bottom surface, and a top surface,
wherein the forming of the gate insulating layer (GI) comprises forming an interface layer (IL) on the opposite side surfaces, the bottom surface, and the top surface of the first semiconductor pattern (SP1), and
wherein a formation rate of the interface layer (IL) on the opposite side surfaces of the first semiconductor pattern (SP1) is higher than a formation rate of the interface layer (IL) on the bottom and top surfaces of the first semiconductor pattern (SP1),
wherein the opposite side surfaces of the first semiconductor pattern (SP1) comprise a first crystallographic plane,
the top and bottom surfaces of the first semiconductor pattern (SP1) comprise a second crystallographic plane, and
a formation rate of the interface layer (IL) on the first crystallographic plane is higher than a formation rate of the interface layer (IL) on the second crystallographic plane,
wherein a thickness of the gate insulating layer (GI) is greater on the opposite side surfaces of the first semiconductor pattern (SP1) than on the bottom and top surfaces of the first semiconductor pattern (SP1), the thickness of the gate insulating layer (GI) on the opposite side surfaces being a first thickness (TK1) and a thickness (TK2) of the gate insulating layer (GI) on the bottom and top surfaces of the first semiconductor pattern (SP1) being a second thickness (TK2),
wherein a ratio (TK2/TK1) of the second thickness (TK2) to the first thickness (TK1) falls within the range of 0.3 to 0.8.

12. The method of claim 11, wherein
the interface layer (IL) is further formed on a side surface of the source/drain pattern (SD1), and
a formation rate of the interface layer (IL) on the side surface of the source/drain pattern (SD1) is higher than the formation rate of the interface layer (IL) on the bottom and top surfaces of the first semiconductor pattern (SP1).

## Patentansprüche

1. Halbleitervorrichtung, die Folgendes umfasst:
ein Substrat (100), das eine erste aktive Struktur (AP1) beinhaltet;
eine Kanalstruktur (CH1) auf der aktiven Struktur (AP1), wobei die Kanalstruktur (CH1) eine Vielzahl von Halbleiterstrukturen (SP1, SP2, SP3) beinhaltet, die vertikal gestapelt sind, um voneinander beabstandet zu sein;
eine Source-/Drain- Struktur (SD1), die mit der Vielzahl von Halbleiterstrukturen (SP1, SP2, SP3) verbunden ist;
eine Gate-Elektrode (GE) auf der Vielzahl von Halbleiterstrukturen (SP1, SP2, SP3), wobei sich die Gate-Elektrode (GE) in einer ersten Richtung erstreckt, die zu einer Oberseite des Substrats (100) parallel ist; und
eine Gate-Isolierschicht (GI) zwischen der Vielzahl von Halbleiterstrukturen (SP1, SP2, SP3) und der Gate-Elektrode (GE),
wobei eine erste Halbleiterstruktur (SP1) der Vielzahl von Halbleiterstrukturen (SP1, SP2, SP3) entgegengesetzte Seitenflächen, die zueinander in der ersten Richtung entgegengesetzt sind, eine Unterseite und eine Oberseite beinhaltet,
wobei die Gate-Isolierschicht (GI) die entgegengesetzten Seitenflächen der ersten Halbleiterstruktur (SP1), die Unterseite der ersten Halbleiterstruktur (SP1) und die Oberseite der ersten Halbleiterstruktur (SP1) bedeckt,
wobei die Gate-Isolierschicht (GI) Folgendes beinhaltet:
einen ersten Bereich (PA1) auf einer der entgegengesetzten Seitenflächen der ersten Halbleiterstruktur (SP1); und
einen zweiten Bereich (PA2) auf einer der Oberseite der ersten Halbleiterstruktur (SP1) oder der Unterseite der ersten Halbleiterstruktur (SP1), und
eine erste Dicke (TK1) des ersten Bereichs (PA1) in der ersten Richtung größer als eine zweite Dicke (TK2) des zweiten Bereichs (PA2) in einer zweiten Richtung, die zu der Oberseite des Substrats (100) senkrecht ist, ist, wobei ein Verhältnis (TK2/TK1) der zweiten Dicke (TK2) zu der ersten Dicke (TK1) in den Bereich von 0,3 bis 0,8 fällt.

2. Halbleitervorrichtung nach Anspruch 1, wobei die Gate-Isolierschicht (GI) Folgendes umfasst:
eine Grenzschicht (IL), die die erste Halbleiterstruktur (SP1) direkt bedeckt, und
eine High-k-Dielektrikumschicht (HK), die sich auf der Grenzschicht (IL) befindet.

3. Halbleitervorrichtung nach Anspruch 2, wobei eine Dicke in der ersten Richtung der Grenzschicht (IL) des ersten Bereichs (PA1) größer ist als eine Dicke in der zweiten Richtung der Grenzschicht (IL) des zweiten Bereichs (PA2).

4. Halbleitervorrichtung nach Anspruch 2 oder Anspruch 3, wobei eine Dicke in der ersten Richtung der High-k-Dielektrikumschicht (HK) des ersten Bereichs (PA1) größer ist als eine Dicke in der zweiten Richtung der High-k-Dielektrikumschicht (HK) des zweiten Bereichs (PA2).

5. Halbleitervorrichtung nach einem der Ansprüche 2-4, wobei:
die Gate-Isolierschicht (GI) weiter eine Zwischenschicht (IDL) zwischen der Grenzflächenschicht (IL) und der High-k-Dielektrikumschicht (HK) umfasst, und
sich die Zwischenschicht (IDL) selektiv auf dem ersten Bereich (PA1) derart befindet, dass der zweite Bereich (PA2) durch die Zwischenschicht (IDL) freigelegt ist.

6. Halbleitervorrichtung nach Anspruch 5, wobei
die eine der entgegengesetzten Seitenflächen der ersten Halbleiterstruktur (SP1) eine erste kristallographische Ebene aufweist, die zu der ersten Richtung senkrecht ist, und
die eine der Oberflächen der ersten Halbleiterstruktur (SP1) oder der Unterseite der ersten Halbleiterstruktur (SP1) eine zweite kristallographische Ebene aufweist, die zu der zweiten Richtung senkrecht ist.

7. Halbleitervorrichtung nach Anspruch 6, wobei
die erste kristallographische Ebene eine {1 1 0} kristallographische Ebene ist, und
die zweite kristallographische Ebene eine {1 0 0} kristallographische Ebene ist.

8. Halbleitervorrichtung nach einem vorstehenden Anspruch, wobei
die Gate-Elektrode (GE) einen Abschnitt (PO2) umfasst, der sich zwischen der ersten Halbleiterstruktur (SP1) und einer zweiten Halbleiterstruktur (SP2) befindet.
der Abschnitt (PO2) der Gate-Elektrode (GE) an die zweite Halbleiterstruktur (SP2) angrenzt,
die Gate-Isolierschicht (GI) einen dritten Bereich (PA1) zwischen dem Abschnitt (PO2)
(PA2) der Gate-Elektrode (GE) und der Source-/Drain- Struktur (SD1) und einen vierten Bereich (PA2) zwischen dem Abschnitt (PO2) der Gate-Elektrode (GE) und der zweiten Halbleiterstruktur (SP2) umfasst, und
eine Dicke des dritten Bereichs (PA1) senkrecht zu der zweiten Richtung größer als eine Dicke des vierten Bereichs (PA2) in der zweiten Richtung ist.

9. Halbleitervorrichtung nach Anspruch 8, wobei der dritte Bereich (PA1) der Gate-Isolierschicht (GI) eine Seitenfläche der Source-/Drain- Struktur (SD1) direkt bedeckt.

10. Halbleitervorrichtung nach Anspruch 9, wobei
die Source-/Drain-Struktur (SD1) einen vorragenden Abschnitt umfasst, der in Richtung des Abschnitts der Gate-Elektrode (GE) vorragt, und
die Seitenfläche (SW) der Source-/Drain-Struktur (SD1) ein wellenförmiges Profil derart aufweist, dass eine Position der Seitenfläche (SW) senkrecht zu der zweiten Richtung oszilliert, während sich die Seitenfläche (SW) der Source-/Drain-Struktur (SD1) in die zweite Richtung erstreckt.

11. Verfahren zum Fertigen einer Halbleitervorrichtung, wobei das Verfahren Folgendes umfasst:
Bilden einer Stapelungsstruktur auf einem Substrat (100), wobei die Stapelungsstruktur abwechselnd gestapelte aktive Schichten und Opferschichten beinhaltet;
Bilden einer Opferstruktur, die sich in einer ersten Richtung, die sich parallel zu einer Oberseite des Substrats (100) erstreckt, auf der Stapelungsstruktur erstreckt;
Ätzen der Stapelungsstruktur, die an eine Seite der Opferstruktur angrenzt, um eine Vertiefung zu bilden;
Bilden einer Source-/Drain-Struktur (SD1) in der Vertiefung, wobei die aktiven Schichten, die mit der Source-/Drain-Struktur (SD1) verbunden sind, Halbleiterstrukturen bilden, die eine Kanalstruktur bilden;
Entfernen der Opferstruktur und der Opferschichten, um die Halbleiterstrukturen freizulegen; und
sequenzielles Bilden einer Gate-Isolierschicht (GI) und einer Gate-Elektrode (GE) auf der freigelegten ersten bis dritten Halbleiterstruktur,
wobei eine erste Halbleiterstruktur (SP1) der Halbleiterstrukturen entgegengesetzte Seitenflächen, die zueinander in der ersten Richtung entgegengesetzt sind, eine Unterseite und eine Oberseite beinhaltet,
wobei das Bilden der Gate-Isolierschicht (GI) das Bilden einer Grenzflächenschicht (IL) auf den entgegengesetzten Seitenflächen, der Unterseite und der Oberseite der ersten Halbleiterstruktur (SP1) umfasst, und
wobei eine Bildungsrate der Grenzschicht (IL) auf den entgegengesetzten Seitenflächen der ersten Halbleiterstruktur (SP1) höher ist als eine Bildungsrate der Grenzschicht (IL) auf der Unter- und Oberseite der ersten Halbleiterstruktur (SP1),
wobei die entgegengesetzten Seitenflächen der ersten Halbleiterstruktur (SP1) eine erste kristallographische Ebene umfassen,
die Ober- und Unterseite der ersten Halbleiterstruktur (SP1) eine zweite kristallographische Ebene umfassen, und
eine Bildungsrate der Grenzschicht (IL) auf der ersten kristallographischen Ebene höher als eine Bildungsrate der Grenzschicht (IL) auf der zweiten kristallographischen Ebene ist,
wobei eine Dicke der Gate-Isolierschicht (GI) auf den entgegengesetzten Seitenflächen der ersten Halbleiterstruktur (SP1) größer als auf der Unter- und Oberseite der ersten Halbleiterstruktur (SP1) ist, die Dicke der Gate-Isolierschicht (GI) auf den entgegengesetzten Seitenflächen eine erste Dicke (TK1) ist, und eine Dicke (TK2) der Gate-Isolierschicht (GI) auf der Unter- und Oberseite der ersten Halbleiterstruktur (SP1) eine zweite Dicke (TK2) ist,
wobei ein Verhältnis (TK2/TK1) der zweiten Dicke (TK2) zu der ersten Dicke (TK1) in den Bereich von 0,3 bis 0,8 fällt.

12. Verfahren nach Anspruch 11, wobei
die Grenzschicht (IL) weiter auf einer Seitenfläche der Source-/Drain-Struktur (SD1) gebildet wird, und
eine Bildungsrate der Grenzschicht (IL) auf der Seitenfläche der Source-/Drain-Struktur (SD1) höher als die Bildungsrate der Grenzschicht (IL) auf der Unter- und Oberseite der ersten Halbleiterstruktur (SP1) ist.

## Revendications

1. Dispositif semi-conducteur, comprenant :
un substrat (100) incluant un motif actif (AP1) ;
un motif de canal (CH1) sur le motif actif (AP1), le motif de canal (CH1) incluant une pluralité de motifs semi-conducteurs (SP1, SP2, SP3) empilés verticalement pour être espacés les uns des autres ;
un motif source/drain (SD1) connecté à la pluralité de motifs semi-conducteurs (SP1, SP2, SP3) ;
une électrode de grille (GE) sur la pluralité de motifs semi-conducteurs (SP1, SP2, SP3), l'électrode de grille (GE) s'étendant dans une première direction qui est parallèle à une surface supérieure du substrat (100) ; et
une couche isolante de grille (GI) entre la pluralité de motifs semi-conducteurs (SP1, SP2, SP3) et l'électrode de grille (GE),
dans lequel un premier motif semi-conducteur (SP1) de la pluralité de motifs semi-conducteurs (SP1, SP2, SP3) inclut des surfaces latérales opposées, qui sont opposées l'une à l'autre dans la première direction, une surface inférieure et une surface supérieure,
dans lequel la couche isolante de grille (GI) recouvre les surfaces latérales opposées du premier motif semi-conducteur (SP1), la surface inférieure du premier motif semi-conducteur (SP1) et la surface supérieure du premier motif semi-conducteur (SP1),
dans lequel la couche isolante de grille (GI) inclut :
une première région (PA1) sur une parmi les surfaces latérales opposées du premier motif semi-conducteur (SP1) ; et
une deuxième région (PA2) sur une parmi la surface supérieure du premier motif semi-conducteur (SP1) ou la surface inférieure du premier motif semi-conducteur (SP1), et
une première épaisseur (TK1) de la première région (PA1) dans la première direction est supérieure à une deuxième épaisseur (TK2) de la deuxième région (PA2) dans une deuxième direction qui est perpendiculaire à la surface supérieure du substrat (100), dans lequel un rapport (TK2/TK1) de la deuxième épaisseur (TK2) à la première épaisseur (TK1) se situe dans la plage de 0,3 à 0,8.

2. Dispositif semi-conducteur selon la revendication 1, dans lequel la couche isolante de grille (GI) comprend :
une couche d'interface (IL) qui recouvre directement le premier motif semi-conducteur (SP1), et
une couche diélectrique à constante diélectrique élevée (HK) qui est sur la couche d'interface (IL).

3. Dispositif semi-conducteur selon la revendication 2, dans lequel une épaisseur dans la première direction de la couche d'interface (IL) de la première région (PA1) est supérieure à une épaisseur dans la deuxième direction de la couche d'interface (IL) de la deuxième région (PA2).

4. Dispositif semi-conducteur selon la revendication 2 ou la revendication 3, dans lequel une épaisseur dans la première direction de la couche diélectrique à constante diélectrique élevée (HK) de la première région (PA1) est supérieure à une épaisseur dans la deuxième direction de la couche diélectrique à constante diélectrique élevée (HK) de la deuxième région (PA2).

5. Dispositif semi-conducteur selon l'une quelconque des revendications 2-4, dans lequel
la couche isolante de grille (GI) comprend en outre une couche intermédiaire (IDL) entre la couche d'interface (IL) et la couche diélectrique à constante diélectrique élevée (HK), et
la couche intermédiaire (IDL) est sélectivement sur la première région (PA1) de sorte que la deuxième région (PA2) soit exposée par la couche intermédiaire (IDL).

6. Dispositif semi-conducteur selon la revendication 5, dans lequel
la surface parmi les surfaces latérales opposées du premier motif semi-conducteur (SP1) comprend un premier plan cristallographique qui est normal à la première direction, et
la surface parmi la surface supérieure du premier motif semi-conducteur (SP1) ou la surface inférieure du premier motif semi-conducteur (SP1) comprend un second plan cristallographique qui est normal à la deuxième direction.

7. Dispositif semi-conducteur selon la revendication 6, dans lequel
le premier plan cristallographique est un plan cristallographique {1 1 0}, et
le second plan cristallographique est un plan cristallographique {1 0 0}.

8. Dispositif semi-conducteur selon une quelconque revendication précédente, dans lequel
l'électrode de grille (GE) comprend une partie (PO2) qui est entre le premier motif semi-conducteur (SP1) et un deuxième motif semi-conducteur (SP2),
la partie (PO2) de l'électrode de grille (GE) est adjacente au deuxième motif semi-conducteur (SP2),
la couche isolante de grille (GI) comprend une troisième région (PA1) entre la partie (PO2) de l'électrode de grille (GE) et le motif source/drain (SD1) et une quatrième région (PA2) entre la partie (PO2) de l'électrode de grille (GE) et le deuxième motif semi-conducteur (SP2), et
une épaisseur de la troisième région (PA1) perpendiculaire à la deuxième direction est supérieure à une épaisseur de la quatrième région (PA2) dans la deuxième direction.

9. Dispositif semi-conducteur selon la revendication 8, dans lequel la troisième région (PA1) de la couche isolante de grille (GI) recouvre directement une surface latérale du motif source/drain (SD1).

10. Dispositif semi-conducteur selon la revendication 9, dans lequel
le motif source/drain (SD1) comprend une partie saillante faisant saillie vers la partie de l'électrode de grille (GE), et
la surface latérale (SW) du motif source/drain (SD1) présente un profil ondulé de sorte qu'une position de la surface latérale (SW) oscille perpendiculairement à la deuxième direction à mesure que la surface latérale (SW) du motif source/drain (SD1) s'étend dans la deuxième direction.

11. Procédé de fabrication d'un dispositif semi-conducteur, le procédé comprenant :
la formation d'un motif d'empilement sur un substrat (100), le motif d'empilement incluant des couches actives et des couches sacrificielles, qui sont empilées alternativement ;
la formation d'un motif sacrificiel, qui s'étend dans une première direction s'étendant parallèlement à une surface supérieure du substrat (100), sur le motif d'empilement ;
la gravure du motif d'empilement, qui est adjacent à un côté du motif sacrificiel, pour former un évidement ;
la formation d'un motif source/drain (SD1) dans l'évidement, les couches actives connectées au motif source/drain (SD1) formant des motifs semi-conducteurs constituant un motif de canal ;
le retrait du motif sacrificiel et des couches sacrificielles pour exposer les motifs semi-conducteurs ; et
la formation séquentielle d'une couche isolante de grille (GI) et d'une électrode de grille (GE) sur les motifs semi-conducteurs exposés,
dans lequel un premier motif semi-conducteur (SP1) parmi les motifs semi-conducteurs inclut des surfaces latérales opposées, qui sont opposées l'une à l'autre dans la première direction, une surface inférieure et une surface supérieure,
dans lequel la formation de la couche isolante de grille (GI) comprend la formation d'une couche d'interface (IL) sur les surfaces latérales opposées, la surface inférieure et la surface supérieure du premier motif semi-conducteur (SP1), et
dans lequel un taux de formation de la couche d'interface (IL) sur les surfaces latérales opposées du premier motif semi-conducteur (SP1) est supérieur à un taux de formation de la couche d'interface (IL) sur les surfaces inférieure et supérieure du premier motif semi-conducteur (SP1),
dans lequel les surfaces latérales opposées du premier motif semi-conducteur (SP1) comprennent un premier plan cristallographique,
les surfaces supérieure et inférieure du premier motif semi-conducteur (SP1) comprennent un second plan cristallographique, et
un taux de formation de la couche d'interface (IL) sur le premier plan cristallographique est supérieur à un taux de formation de la couche d'interface (IL) sur le second plan cristallographique,
dans lequel une épaisseur de la couche isolante de grille (GI) est plus grande sur les surfaces latérales opposées du premier motif semi-conducteur (SP1) que sur les surfaces inférieure et supérieure du premier motif semi-conducteur (SP1), l'épaisseur de la couche isolante de grille (GI) sur les surfaces latérales opposées étant une première épaisseur (TK1) et une épaisseur (TK2) de la couche isolante de grille (GI) sur les surfaces inférieure et supérieure du premier motif semi-conducteur (SP1) étant une deuxième épaisseur (TK2),
dans lequel un rapport (TK2/TK1) de la deuxième épaisseur (TK2) à la première épaisseur (TK1) se situe dans la plage de 0,3 à 0,8.

12. Procédé selon la revendication 11, dans lequel
la couche d'interface (IL) est en outre formée sur une surface latérale du motif source/drain (SD1), et
un taux de formation de la couche d'interface (IL) sur la surface latérale du motif source/drain (SD1) est supérieur au taux de formation de la couche d'interface (IL) sur les surfaces inférieure et supérieure du premier motif semi-conducteur (SP1).
